# EUROPEAN PATENT APPLICATION

(11) **EP 3 950 882 A1**
(43) Date of publication of application: **09.02.2022**
(21) Application number: 20782184.4
(22) Date of filing: 16.03.2020
(51) Int. Cl.: C09K 11/06, H05B 33/10, H01L 51/50

(54) **ORGANIC ELECTROLUMINESCENT ELEMENT**

(30) Priority: 29.03.2019 JP 2019067362
(71) Applicant: NIPPON STEEL Chemical & Material Co., Ltd., Tokyo 103-0027 (JP)
(72) Inventor: OGAWA Junya, Tokyo 103-0027 (JP); IKENAGA Yuji, Tokyo 103-0027 (JP); UEDA Tokiko, Tokyo 103-0027 (JP)
(74) Representative: Beckmann, Claus
(86) International application number: PCT/JP2020/011317
(87) International publication number: WO 2020/203202

(57) **Abstract**

Provided is an organic EL device having high efficiency and high driving stability despite having a low driving voltage. The organic EL device has at least one light-emitting layer that is composed of a vapor deposition layer containing a first host selected from among indolocarbazole compounds represented by General Formula (1), a second host selected from among biscarbazole compounds represented by the following General Formula (2), and a light-emitting dopant material: 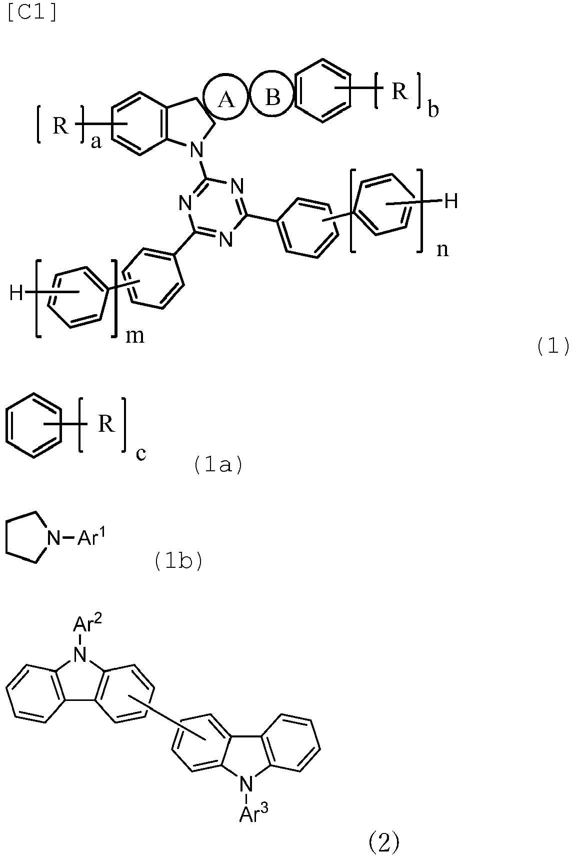 wherein m and n represent the number of repetitions and are an integer of 0 to 4, and m + n ≥ 2 is satisfied; Ar² and Ar³ represent an aromatic hydrocarbon group or a group in which two or three of the aromatic hydrocarbon groups are linked, and at least one is a fused aromatic hydrocarbon group.

## Description

### [Technical Field]

The present invention relates to an organic electroluminescent element (referred to as an organic EL device), and specifically, to an organic EL device having a light-emitting layer containing a first host, a second host, and a light-emitting dopant material.

### [Background Art]

When a voltage is applied to an organic EL device, holes are injected from an anode and electrons are injected from a cathode to a light-emitting layer, respectively. Thus, in the light-emitting layer, injected holes and electrons recombine to generate excitons. In this case, according to statistical rules of electron spins, singlet excitons and triplet excitons are generated at a ratio of 1:3. It is said that the internal quantum efficiency of a fluorescence-emitting organic EL device using light emission from singlet excitons is limited to 25%. On the other hand, it is known that, in a phosphorescent organic EL device using light emission from triplet excitons, when intersystem crossing is efficiently performed from singlet excitons, the internal quantum efficiency is raised to 100%.

However, for phosphorescent organic EL devices, prolonging the lifespan is a technical issue.

Recently, organic EL devices using delayed fluorescence and having high efficiency have been developed. For example, PTL 1 discloses an organic EL device using a Triplet-Triplet Fusion (TTF) mechanism which is one of delayed fluorescence mechanisms. The TTF mechanism utilizes a phenomenon in which singlet excitons are generated due to collision of two triplet excitons, and it is thought that the internal quantum efficiency is theoretically raised to 40%. However, compared to phosphorescent organic EL devices, since the efficiency is low, further improvement in efficiency is required.

On the other hand, PTL 2 discloses an organic EL device using a thermally activated delayed fluorescence (TADF) mechanism. The TADF mechanism utilizes a phenomenon in which reverse intersystem crossing from triplet excitons to singlet excitons is generated in a material having a small energy difference between a singlet level and a triplet level, and it is thought that the internal quantum efficiency is theoretically raised to 100%. However, further improvement in lifespan characteristics is required as in the phosphorescent devices.

### [Citation List]

### [Patent Literature]

[PTL 1] WO2010/134350 A
[PTL 2] WO2011/070963 A
[PTL 3] WO2008/056746 A
[PTL 4] JP2003-133075 A
[PTL 5] WO2013/062075 A
[PTL 6] US2014/0374728 A
[PTL 7] US2014/0197386 A
[PTL 8] US2015/0001488 A
[PTL 9] US2015/0236262 A
[PTL 10] WO2016/194604 A
[PTL 11] WO2011/136755 A

PTL 3 discloses use of an indolocarbazole compound as a host material. PTL 4 discloses use of a biscarbazole compound as a host material.

PTL 5 and 6 disclose use of a biscarbazole compound as a mixed host. PTL 7, 8, 9, and 10 disclose use of an indolocarbazole compound and a biscarbazole compound as a mixed host.

PTL 11 discloses use of a host material in which a plurality of hosts containing an indolocarbazole compound are mixed in advance.

However, none of these can be said to be sufficient, and further improvement is desired.

### [Summary of Invention]

In order to apply an organic EL device to a display device such as a flat panel display or a light source, it is necessary to improve the luminous efficiency of the device and to sufficiently secure stability during driving at the same time. An object of the present invention is to provide an organic EL device having high efficiency and high driving stability despite having a low driving voltage.

The present invention relates to an organic EL device having at least one light-emitting layer between an anode and a cathode which face each other and in which at least one light-emitting layer is comprised of a vapor deposition layer containing a first host selected from among compounds represented by the following General Formula (1), a second host selected from among compounds represented by the following General Formula (2), and a light-emitting dopant material. 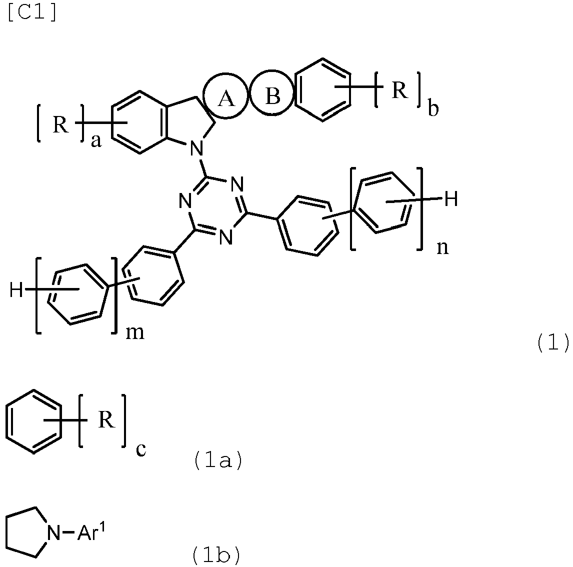 Here, the ring A is an aromatic hydrocarbon ring represented by Formula (1a), the ring B is a heterocycle represented by Formula (1b), and the ring A and the ring B are each fused to an adjacent ring at any position,
Ar¹ represents a phenyl group, a biphenyl group or a terphenyl group,
R's independently represent an aliphatic hydrocarbon group having 1 to 10 carbon atoms, an aromatic hydrocarbon group having 6 to 10 carbon atoms, or an aromatic heterocyclic group having 3 to 12 carbon atoms,
a, b, and c each independently represent an integer of 0 to 3, and
m and n represent the number of repetitions, and each independently represent an integer of 0 to 4, here, m = n never being satisfied, and m + n ≥ 2. 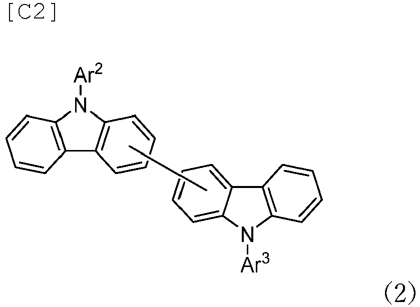
Wherein, Ar² and Ar³ represent an aromatic hydrocarbon group having 6 to 14 carbon atoms or a group in which two or three of the aromatic hydrocarbon groups are linked, and at least one of Ar² and Ar³ is a fused aromatic hydrocarbon group.

Preferable embodiments of General Formula (2) include General Formula (3).

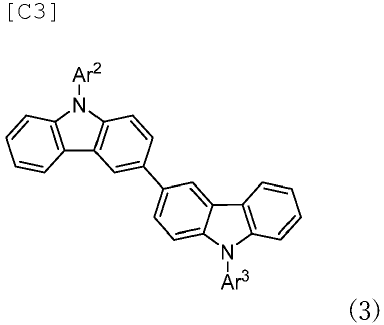

Preferable embodiments of General Formula (1) include General Formula (4) to (9), and General Formula (4), (5), (6), or (7) is preferable, and General Formula (4) is more preferable.

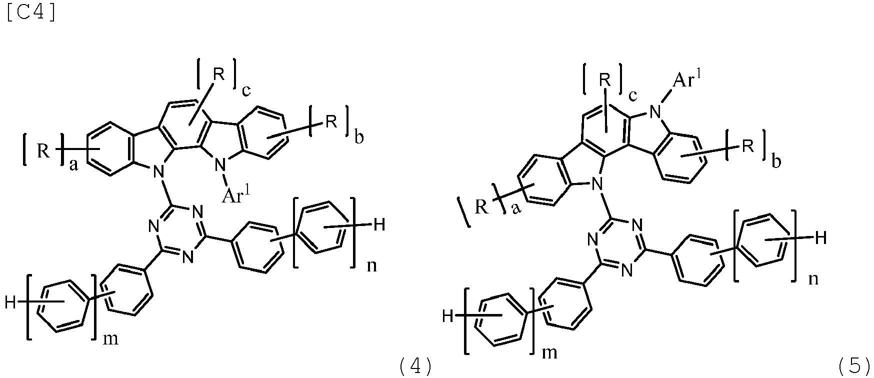

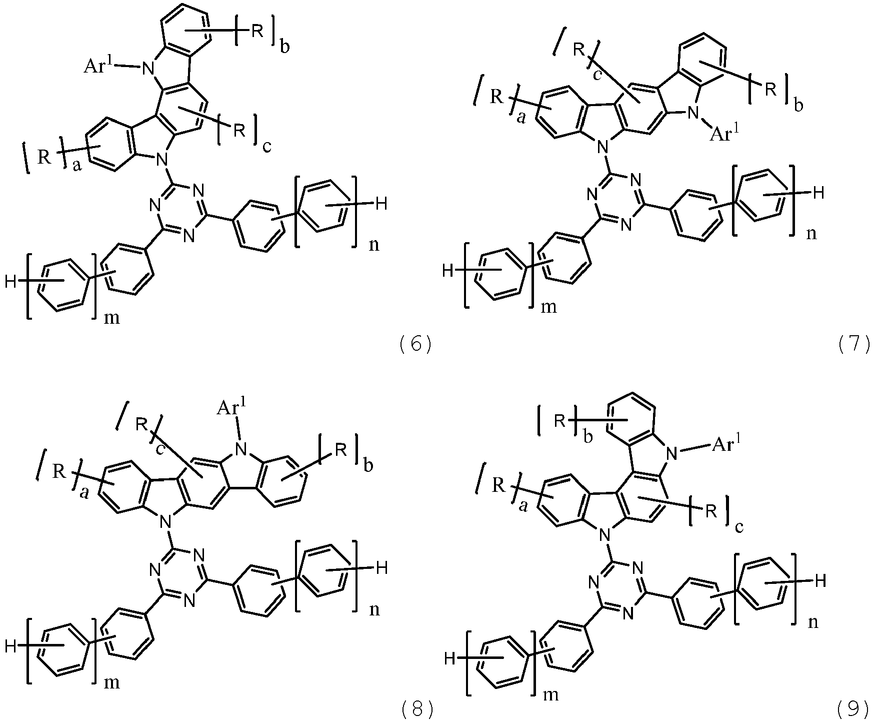

Preferably, the first host and the second host are used by being mixed in advance before vapor deposition. In addition, preferably, a difference of the 50% weight reduction temperature between the first host and the second host is within 20°C, or a proportion of the first host is larger than 20 wt% and less than 55 wt% with respect to a total amount of the first host and the second host.

The light-emitting dopant material can be a phosphorescent dopant material, a fluorescence-emitting dopant material or a thermally activated delayed fluorescence-emitting dopant material. Examples of the phosphorescent dopant material include an organic metal complex containing at least one metal selected from among ruthenium, rhodium, palladium, silver, rhenium, osmium, iridium, platinum and gold.

In addition, preferably, in the organic EL device, a hole blocking layer adjacent to the light-emitting layer is provided, and the hole blocking layer contains a compound represented by General Formula (1).

In addition, the present invention relates to a method of producing an organic electroluminescent device including a process in which, when the above organic electroluminescent device is produced, a first host and a second host are mixed to prepare a pre-mixture, and a host material containing the pre-mixture is then vapor-deposited to

In order to improve device characteristics, it is necessary to increase durability of a material used for an organic layer against charges, and particularly, in the light-emitting layer, it is important to reduce leakage of excitons and charges to surrounding layers. In order to reduce leakage of charges/excitons, alleviating deviation of a light emission area in the light-emitting layer is effective. For this, it is necessary to control both amounts of charges (electrons/holes) injected into the light-emitting layer and both amounts of charges transported in the light-emitting layer such that they are within a preferable range.

Here, the indolocarbazole compound of General Formula (1) has high framework stability and injection and transport properties of both charges can be controlled to some extent according to isomers or substituents thereof. However, it is difficult to independently control both amounts of charges injected and transported so that they are within a preferable range as described above. On the other hand, with the biscarbazole compound of General Formula (2), charge injection and transport properties can be controlled at a high level when types and the number of substituents thereof are changed. In addition, the biscarbazole compound has high amorphous stability and high framework stability like the indolocarbazole compound. Therefore, when a mixture of the indolocarbazole compound and the biscarbazole compound is used, an amount of charges injected into the organic layer can be adjusted to a preferable range, and more favorable device characteristics can be expected therewith. In particular, in the case of a delayed fluorescence-emitting EL device or a phosphorescent EL device, a lowest excited triplet energy sufficiently high to confine the excitation energy generated in the light-emitting layer is provided so that there is no outflow of energy from the inside of the light-emitting layer, and high efficiency and a prolonged lifespan can be achieved at a low voltage.

### [Brief Description of Drawings]

[Fig. 1]

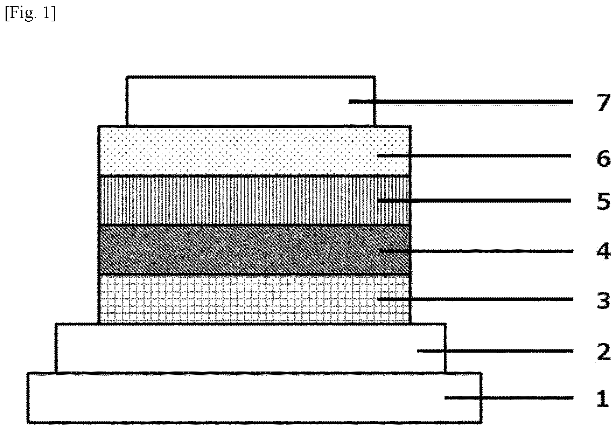

Fig. 1 is a cross-sectional view schematically showing an example of an organic EL device.

### [Description of Embodiments]

An organic EL device of the present invention has at least one light-emitting layer between an anode and a cathode which face each other, and at least one of light-emitting layers is composed of a vapor deposition layer containing a first host, a second host, and a light-emitting dopant material. The vapor deposition layer can be produced according to vacuum vapor deposition. The first host is a compound represented by General Formula (1), and the second host is a compound represented by General Formula (2). The organic EL device has a plurality of organic layers between an anode and a cathode which face each other, but at least one of the plurality of layers is a light-emitting layer, and a plurality of light-emitting layers may be provided.

### General Formula (1) will be described.

The ring A is an aromatic hydrocarbon ring represented by Formula (1a), the ring B is a heterocycle represented by Formula (1b), and the ring A and the ring B are each fused to an adjacent ring at any position.

Ar¹ represents a phenyl group, a biphenyl group, or a terphenyl group. Preferable examples thereof are a phenyl group or a biphenyl group, and more preferable examples thereof are a phenyl group. Here, the biphenyl group is a group represented by -Ph-Ph, and the terphenyl group is a group represented by -Ph-Ph-Ph or Ph(-Ph)-Ph. Here, Ph is a phenyl group or a phenylene group.

R's independently represent an aliphatic hydrocarbon group having 1 to 10 carbon atoms, an aromatic hydrocarbon group having 6 to 10 carbon atoms, or an aromatic heterocyclic group having 3 to 12 carbon atoms. Preferable examples thereof include an aliphatic hydrocarbon group having 1 to 8 carbon atoms, a phenyl group, and an aromatic heterocyclic group having 3 to 9 carbon atoms. More preferable examples thereof include an aliphatic hydrocarbon group having 1 to 6 carbon atoms, a phenyl group, and an aromatic heterocyclic group having 3 to 6 carbon atoms.

Specific examples of the aliphatic hydrocarbon group having 1 to 10 carbon atoms include a methyl group, an ethyl group, a propyl group, a butyl group, a pentyl group, a hexyl group, a heptyl group, an octyl group, a nonyl group, and a decyl group. An alkyl group having 1 to 4 carbon atoms is preferable.

Specific examples of the aromatic hydrocarbon group having 6 to 10 carbon atoms or the aromatic heterocyclic group having 3 to 12 carbon atoms include an aromatic groups formed by taking one H from benzene, naphthalene, pyridine, pyrimidine, triazine, thiophene, isothiazole, thiazole, pyridazine, pyrrole, pyrazole, imidazole, triazole, thiadiazole, pyrazine, furan, isoxazole, oxazole, oxadiazole, quinoline, isoquinoline, quinoxaline, quinazoline, oxadiazole, thiadiazole, benzotriazine, phthalazine, tetrazole, indole, benzofuran, benzothiophene, benzoxazole, benzothiazole, indazole, benzimidazole, benzotriazole, benzoisothiazole, benzothiadiazole, dibenzofuran, dibenzothiophene, dibenzoselenophene, or carbazole. Preferable examples thereof include aromatic groups generated from benzene, pyridine, pyrimidine, triazine, thiophene, isothiazole, thiazole, pyridazine, pyrrole, pyrazole, imidazole, triazole, thiadiazole, pyrazine, furan, isoxazole, oxazole, oxadiazole, quinoline, isoquinoline, quinoxaline, quinazoline, oxadiazole, thiadiazole, benzotriazine, phthalazine, tetrazole, indole, benzofuran, benzothiophene, benzoxazole, benzothiazole, indazole, benzimidazole, benzotriazole, benzoisothiazole, or benzothiadiazole. More preferable examples thereof include aromatic groups generated from benzene, pyridine, pyrimidine, triazine, thiophene, isothiazole, thiazole, pyridazine, pyrrole, pyrazole, imidazole, triazole, thiadiazole, pyrazine, furan, isoxazole, oxazole, or oxadiazole.

a, b, and c represent the number of substitutions, and each independently represent an integer of 0 to 3 and are preferably an integer of 0 or 1. m and n represent the number of repetitions, and each independently represent an integer of 0 to 4, and m = n is never satisfied. Here, m + n is preferably an integer of two or more, and more preferably an integer of 2 or 3.

Specific examples of compounds represented by General Formula (1) are shown below, but the present invention is not limited to such exemplary compounds.

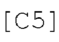

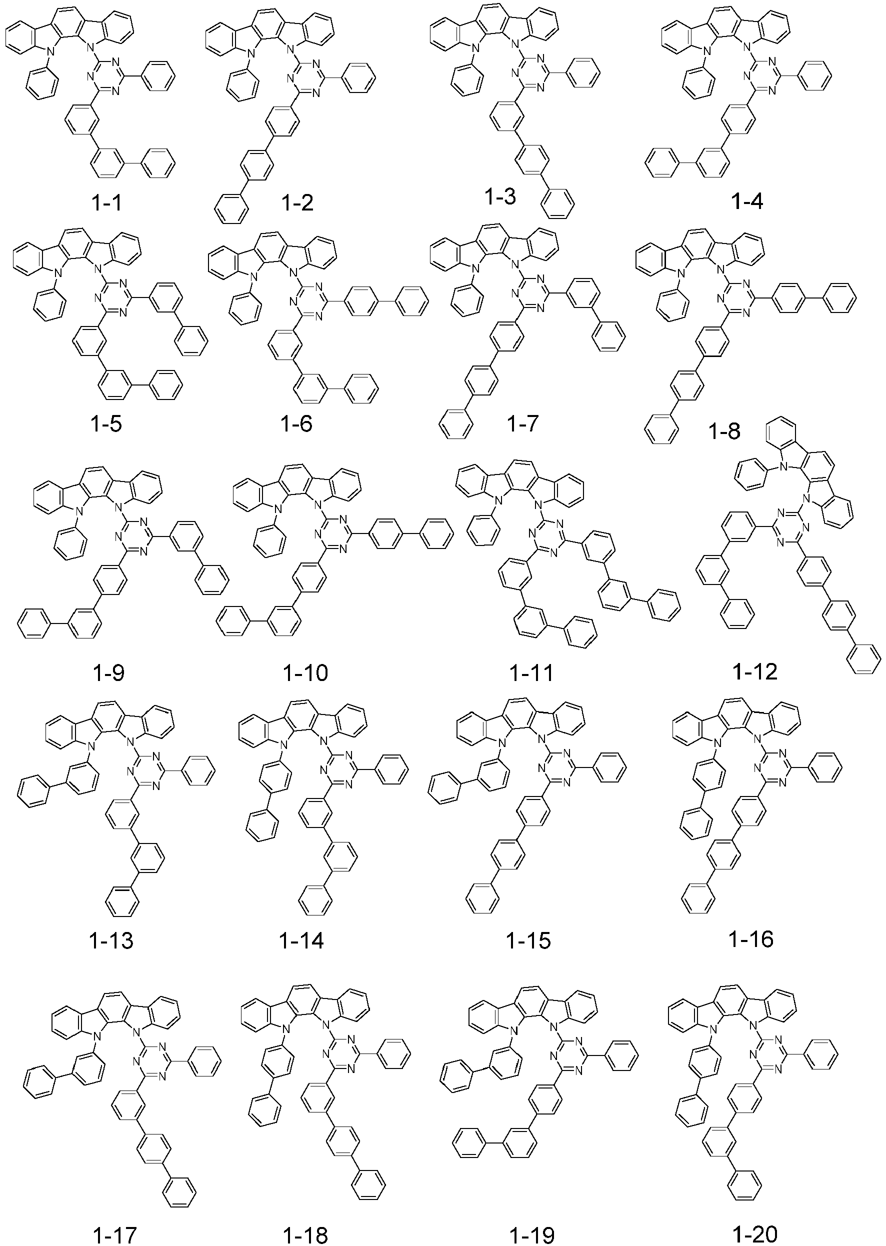

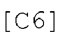

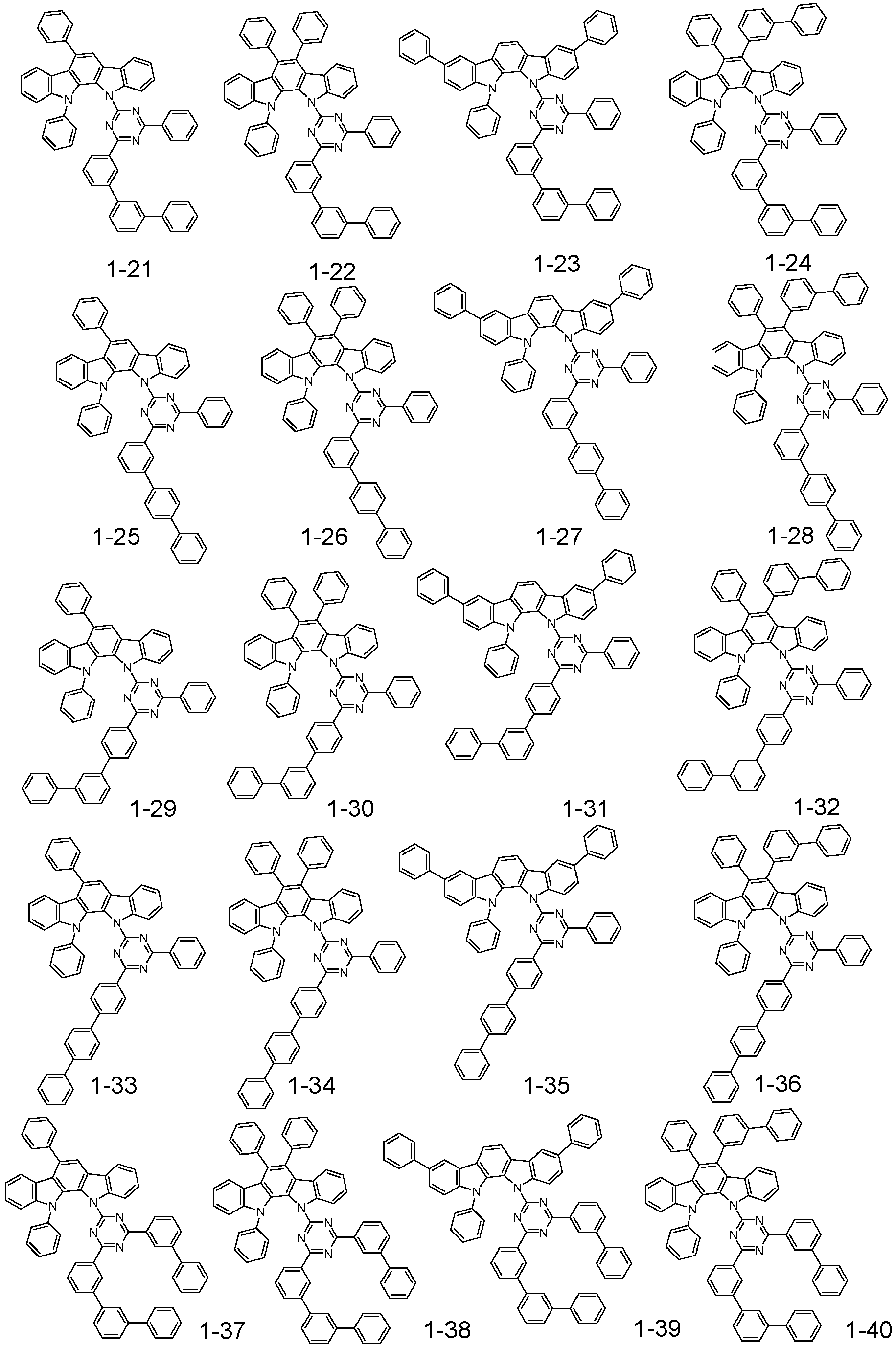

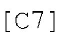

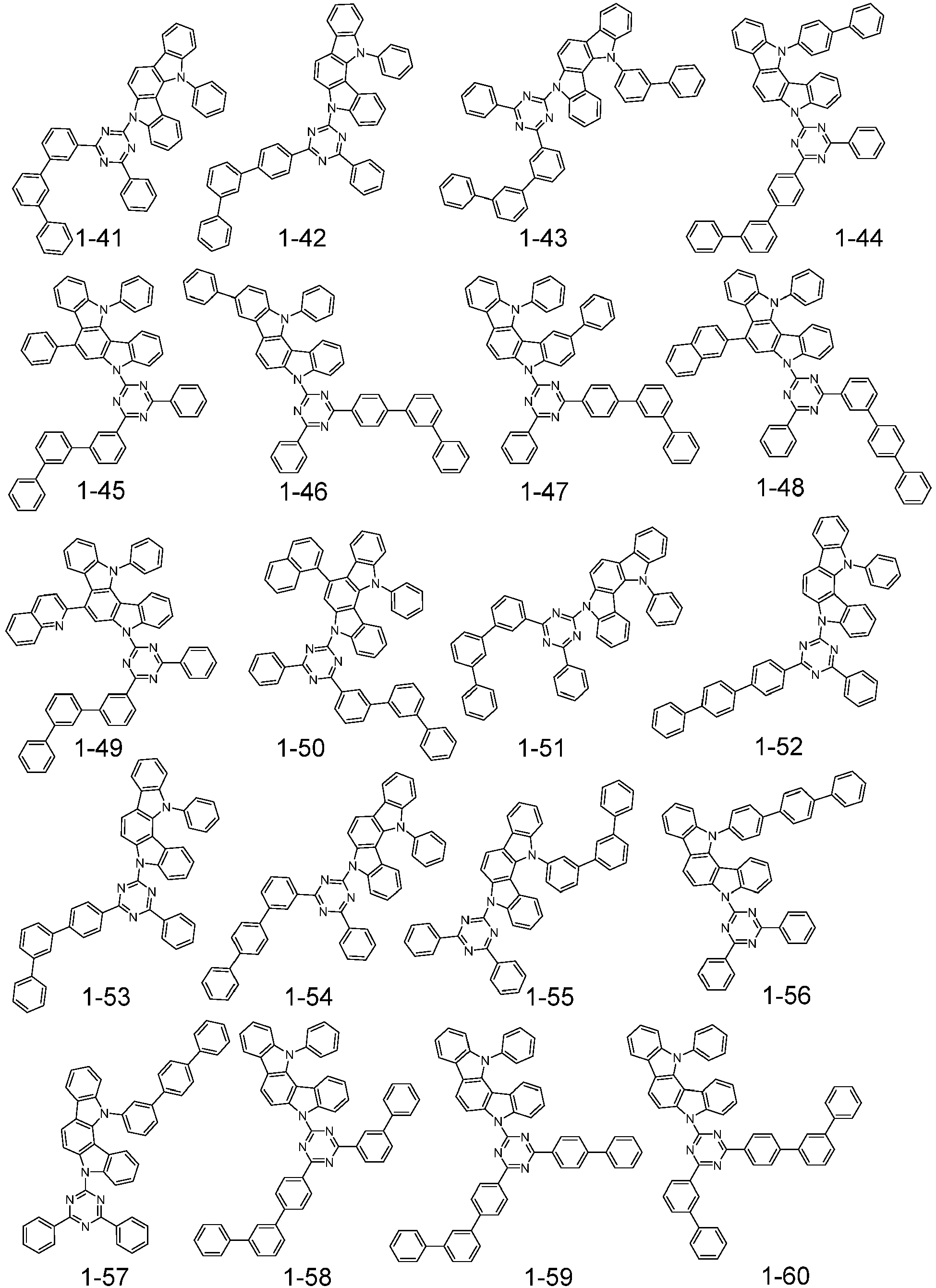

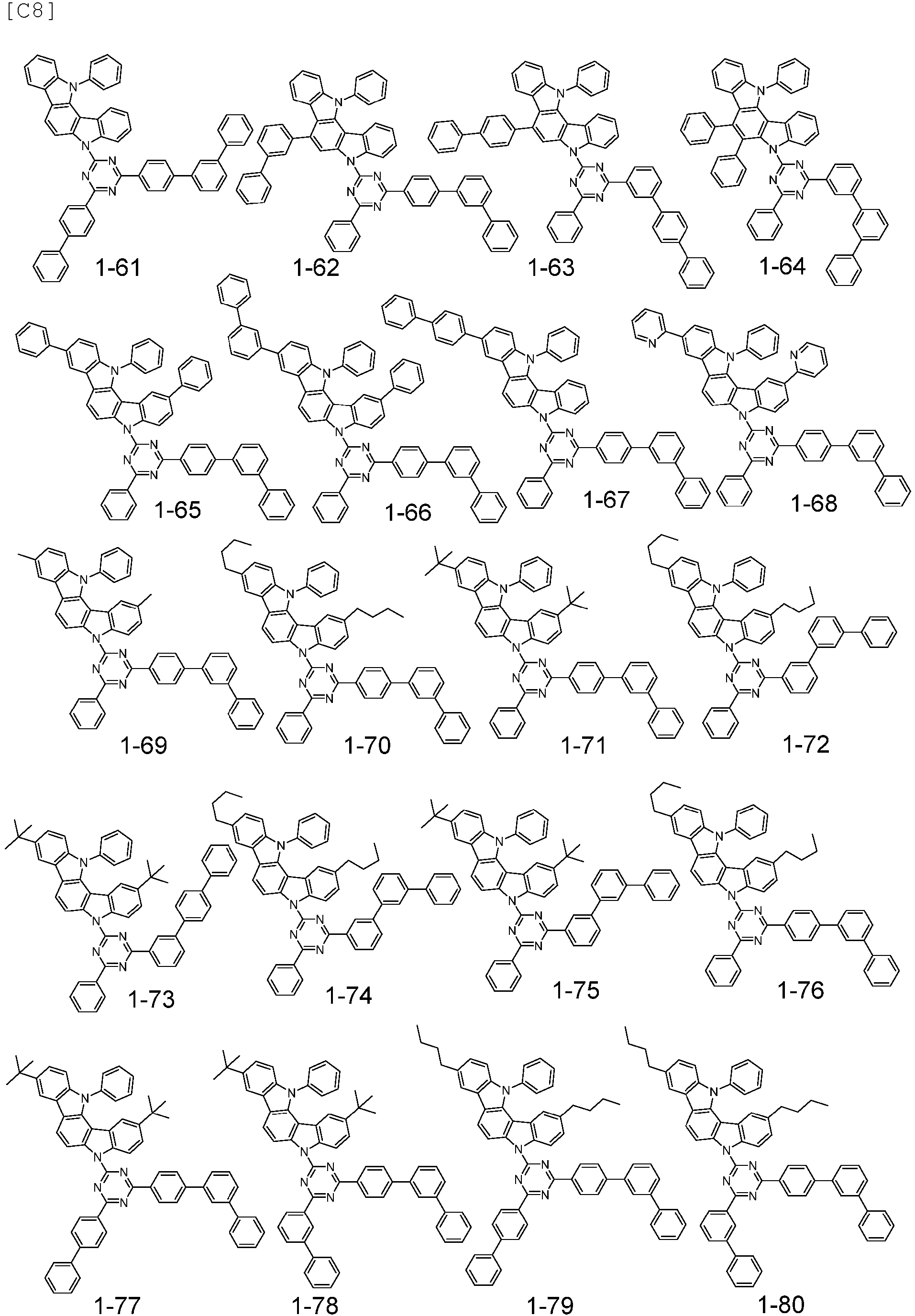

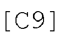

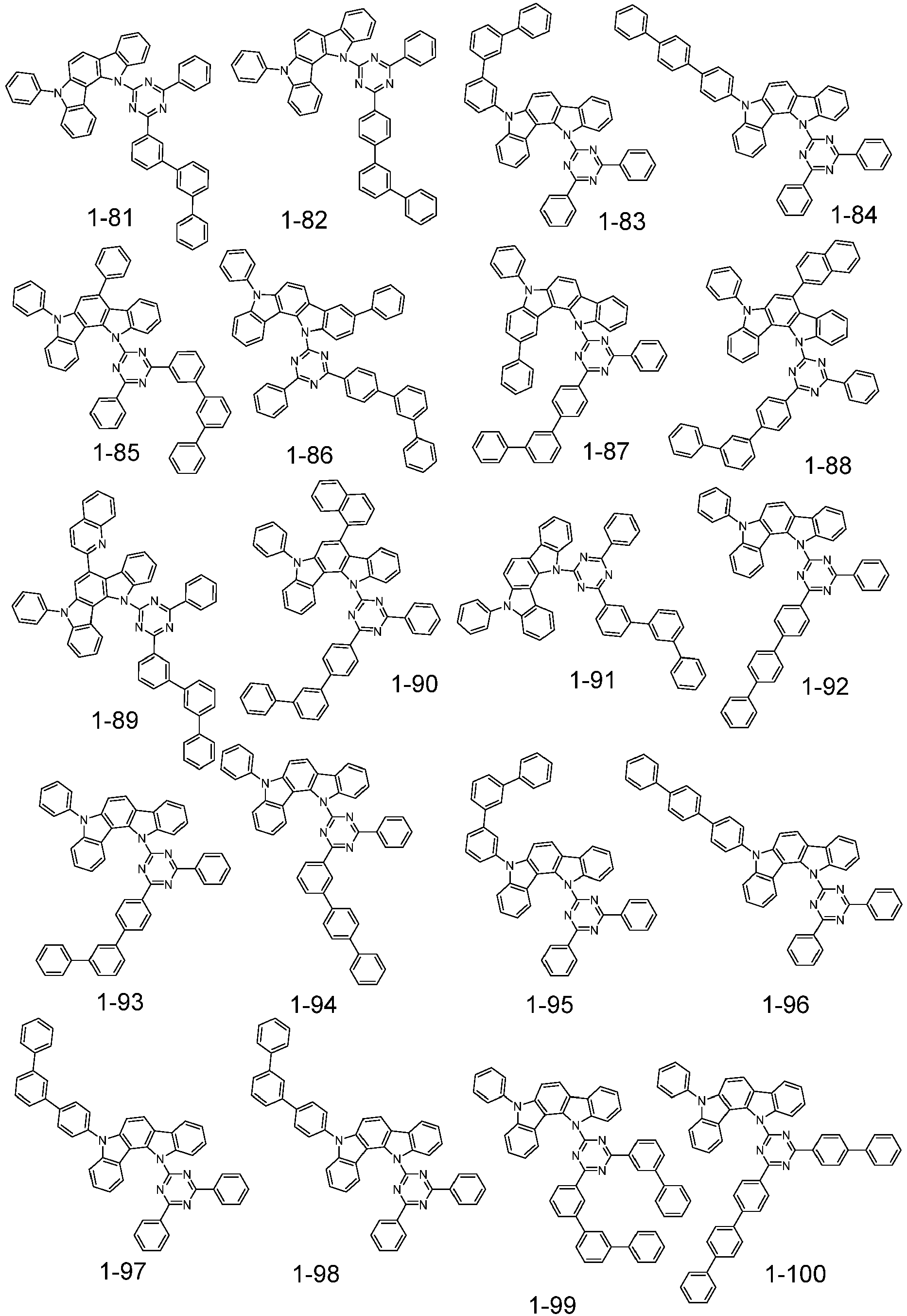

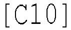

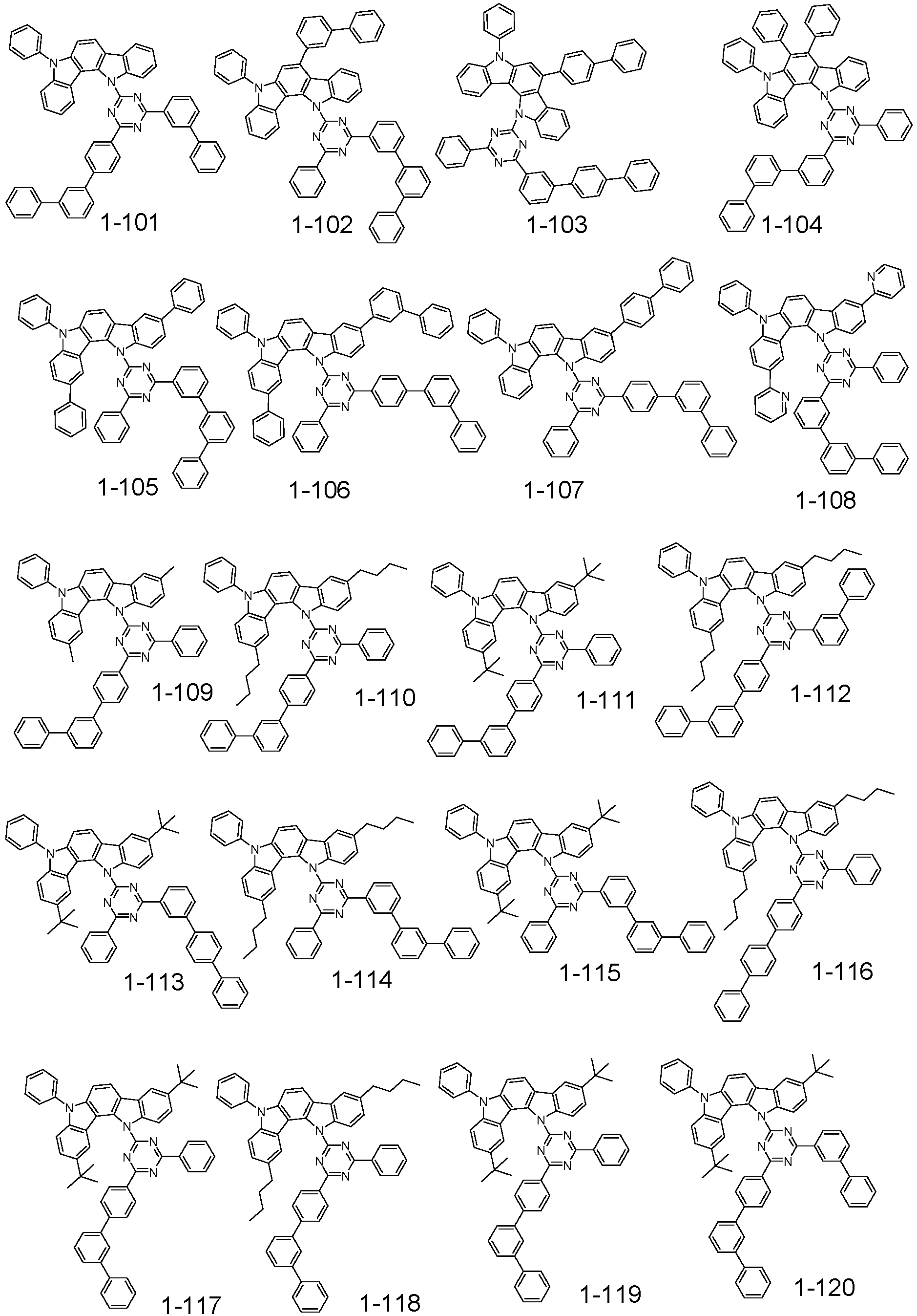

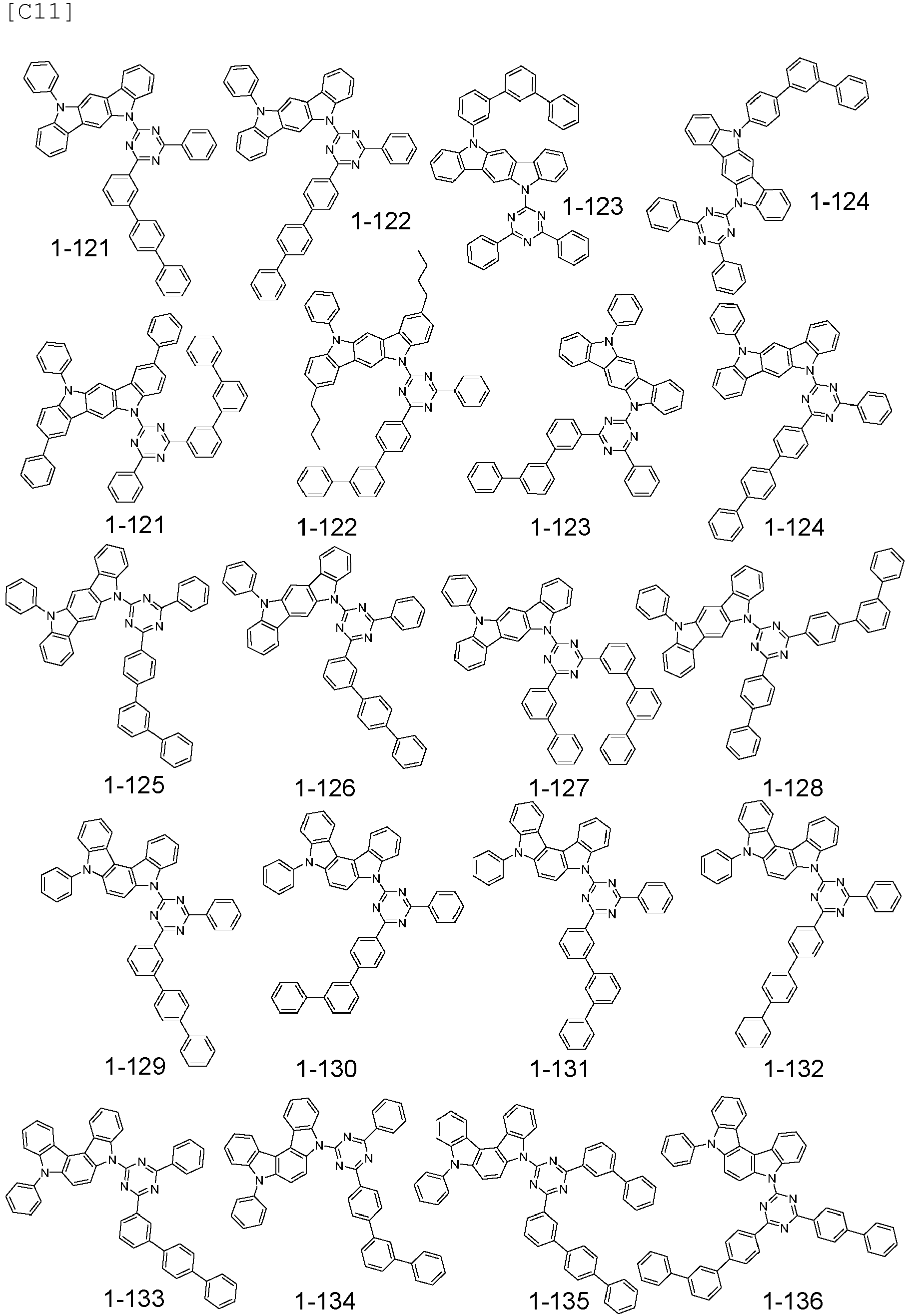

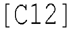

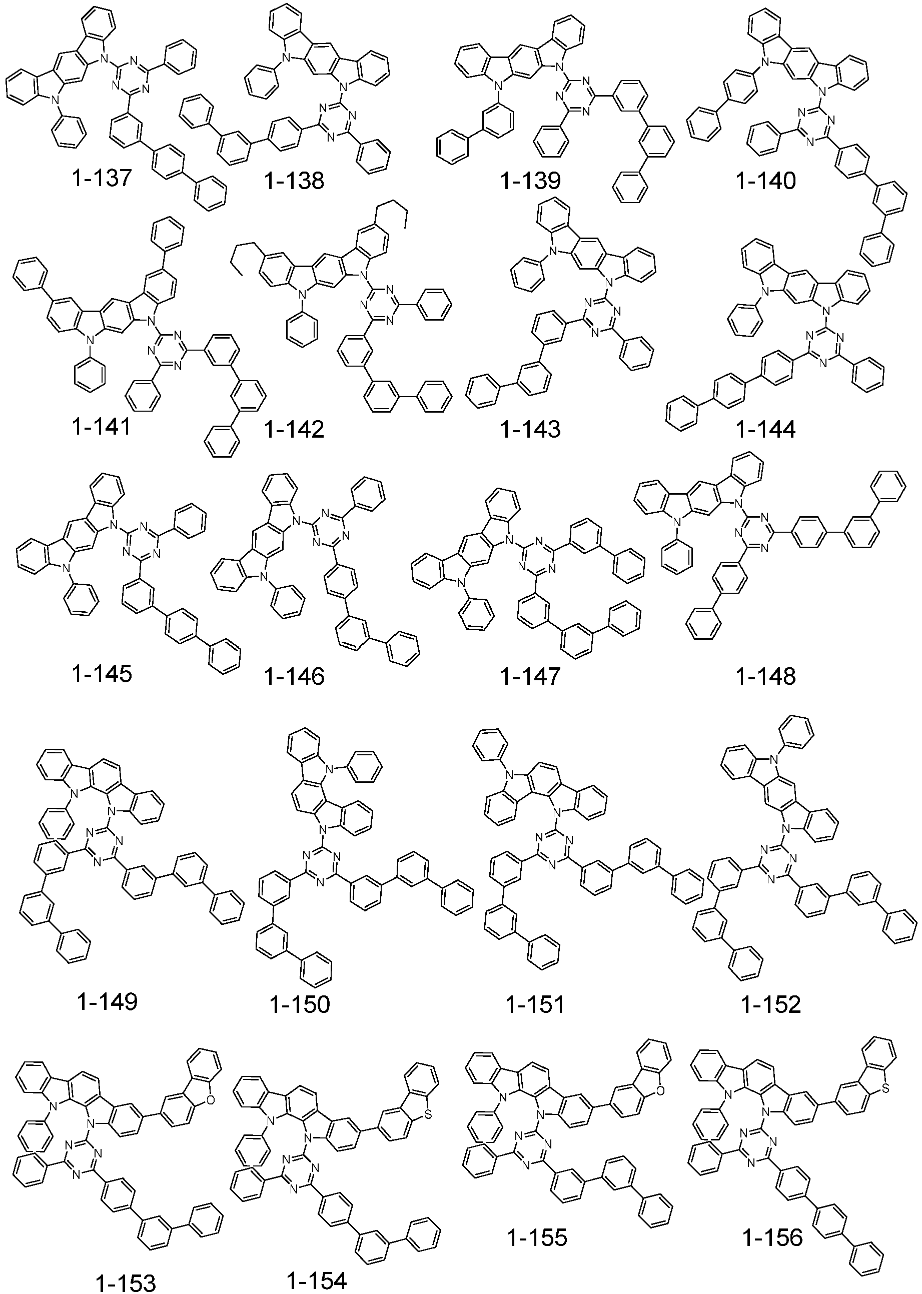

Next, General Formula (2) representing the second host and General Formula (3) representing a preferable embodiment thereof will be described. In General Formula (2) and General Formula (3), the same symbols have the same meanings.

Ar² and Ar³ represent an aromatic hydrocarbon group having 6 to 14 carbon atoms or a linked aromatic group in which two or three of the aromatic hydrocarbon groups are linked, and preferably represent an aromatic hydrocarbon group having 6 to 12 carbon atoms, and more preferably represent an aromatic hydrocarbon group having 6 to 10 carbon atoms, but at least one of Ar² and Ar³ is a fused aromatic hydrocarbon group.

Specific examples of Ar² and Ar³ include an aromatic group and a linked aromatic group formed by taking one H from an aromatic hydrocarbon such as benzene, naphthalene, anthracene, phenanthrene, and fluorene, or a compound in which two aromatic rings of such aromatic hydrocarbons are linked. Preferable examples thereof include an aromatic group generated from benzene, naphthalene, anthracene, or phenanthrene, and a linked aromatic group in which two of these aromatic groups are linked, and more preferable examples thereof include an aromatic group generated from benzene, naphthalene, or phenanthrene. Ar³ is more preferably a naphthyl group or a phenanthryl group. The aromatic group or linked aromatic group may have a substituent, and a preferable substituent is an alkyl group having 1 to 12 carbon atoms or an alkoxy group having 1 to 12 carbon atoms.

Here, the linked aromatic group is represented by, for example, a formula of -Ar⁴-Ar⁵. Here, Ar⁴ and Ar⁵ independently represent an aromatic hydrocarbon group having 6 to 14 carbon atoms. Ar⁴ is a divalent or trivalent group, and Ar⁵ is a monovalent group. Here, aromatic groups constituting the linked aromatic group may be the same as or different from each other.

Specific examples of compounds represented by General Formulae (2) to (3) are shown below, but the present invention is not limited to such exemplary compounds.

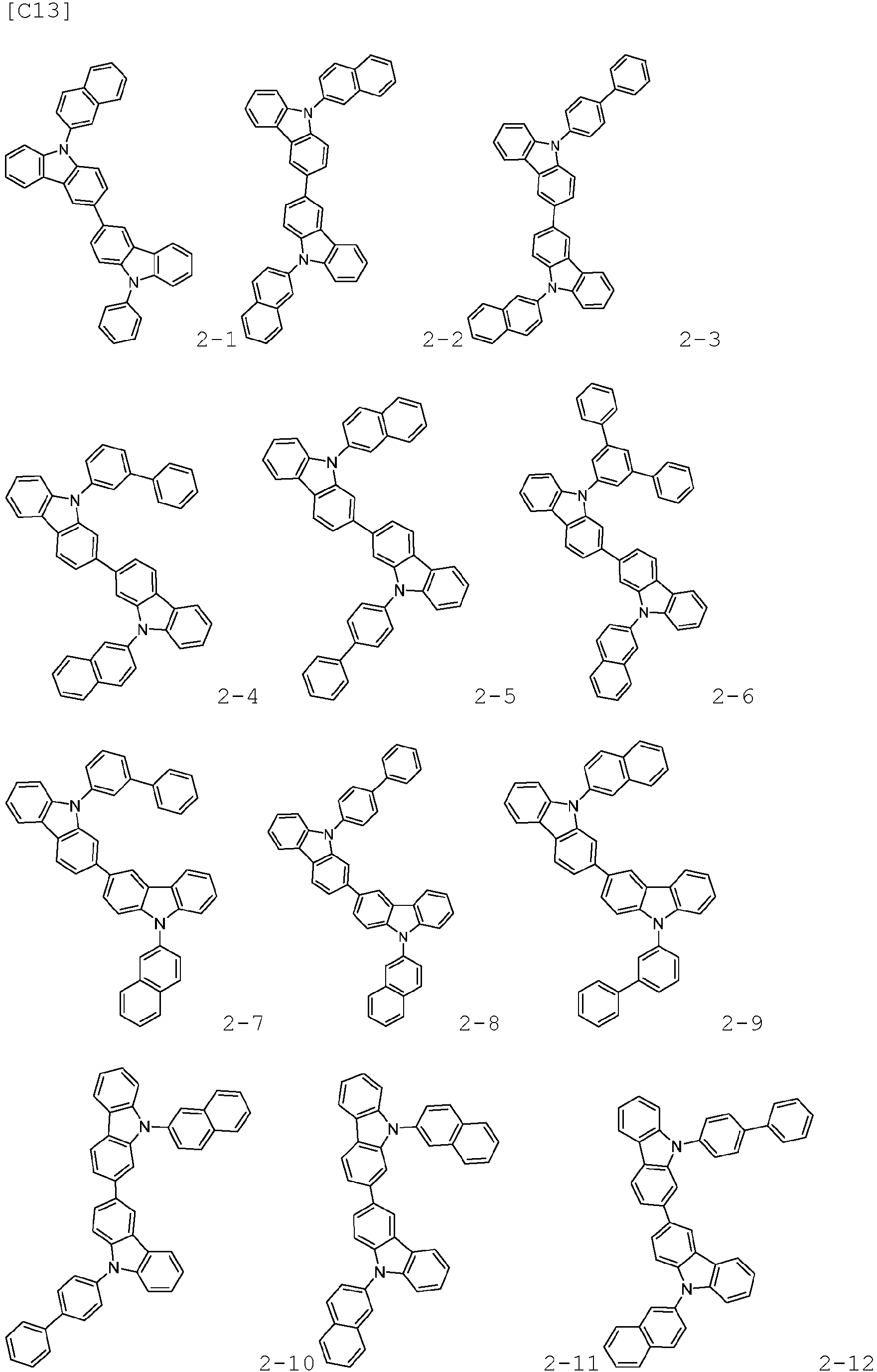

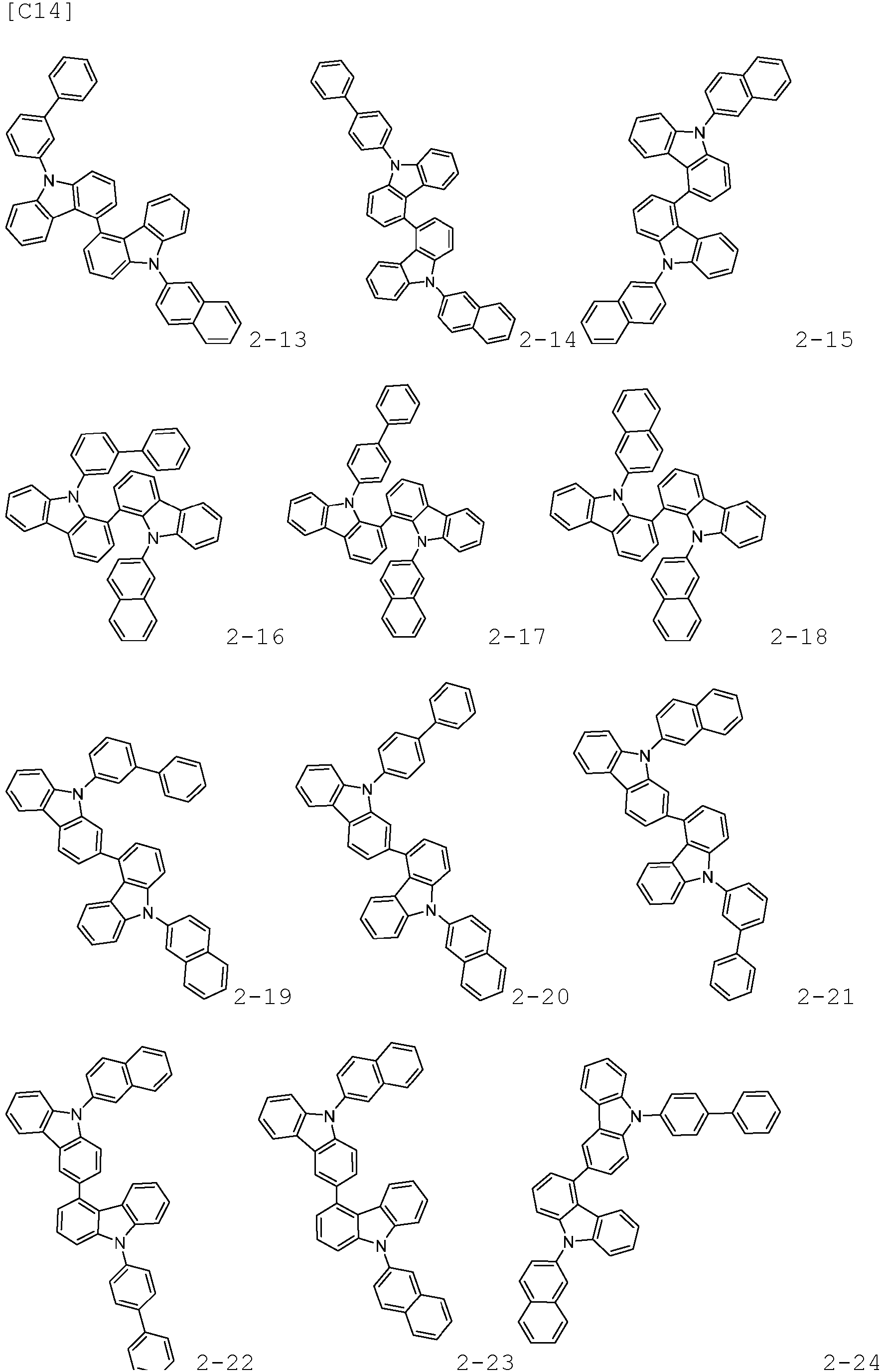

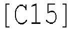

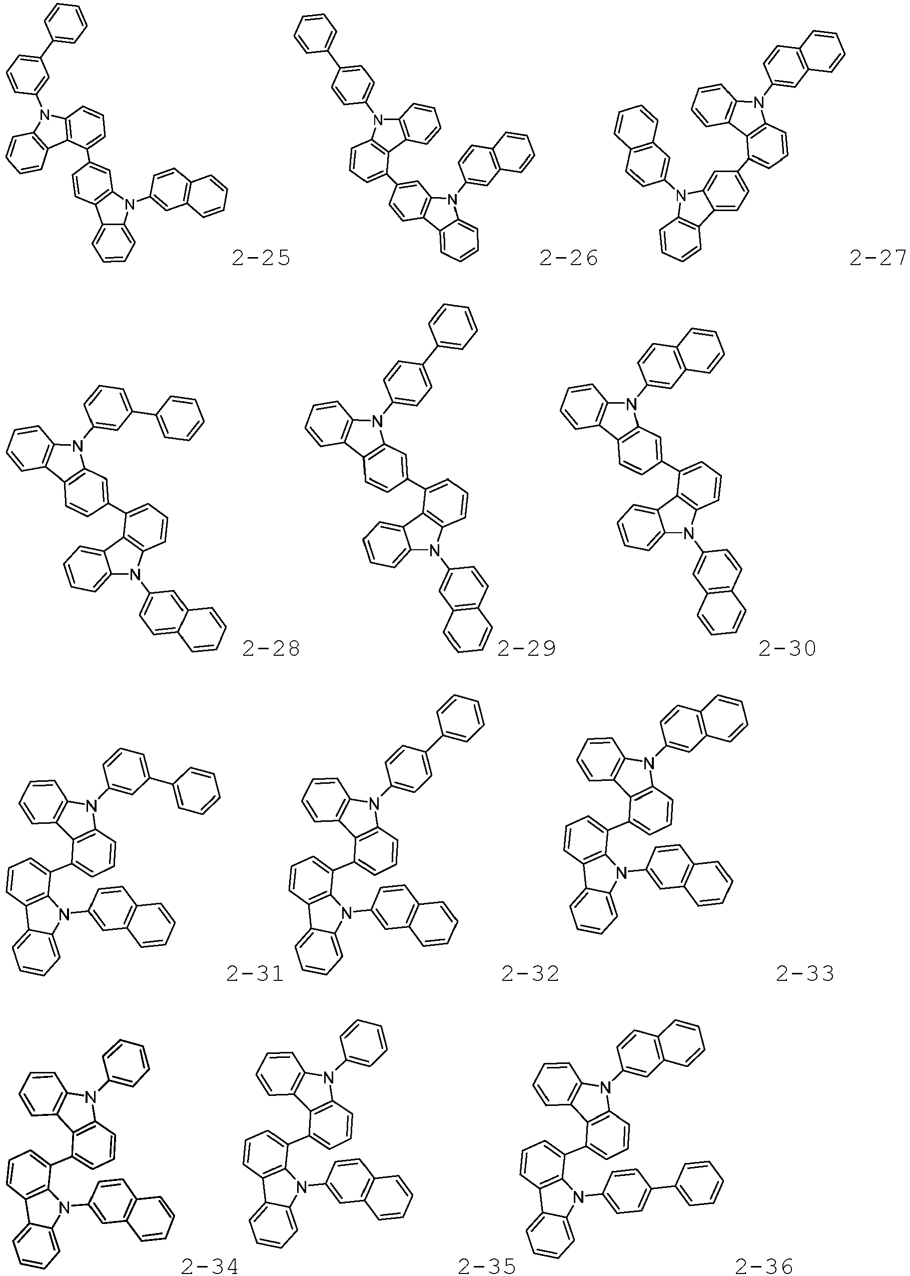

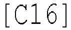

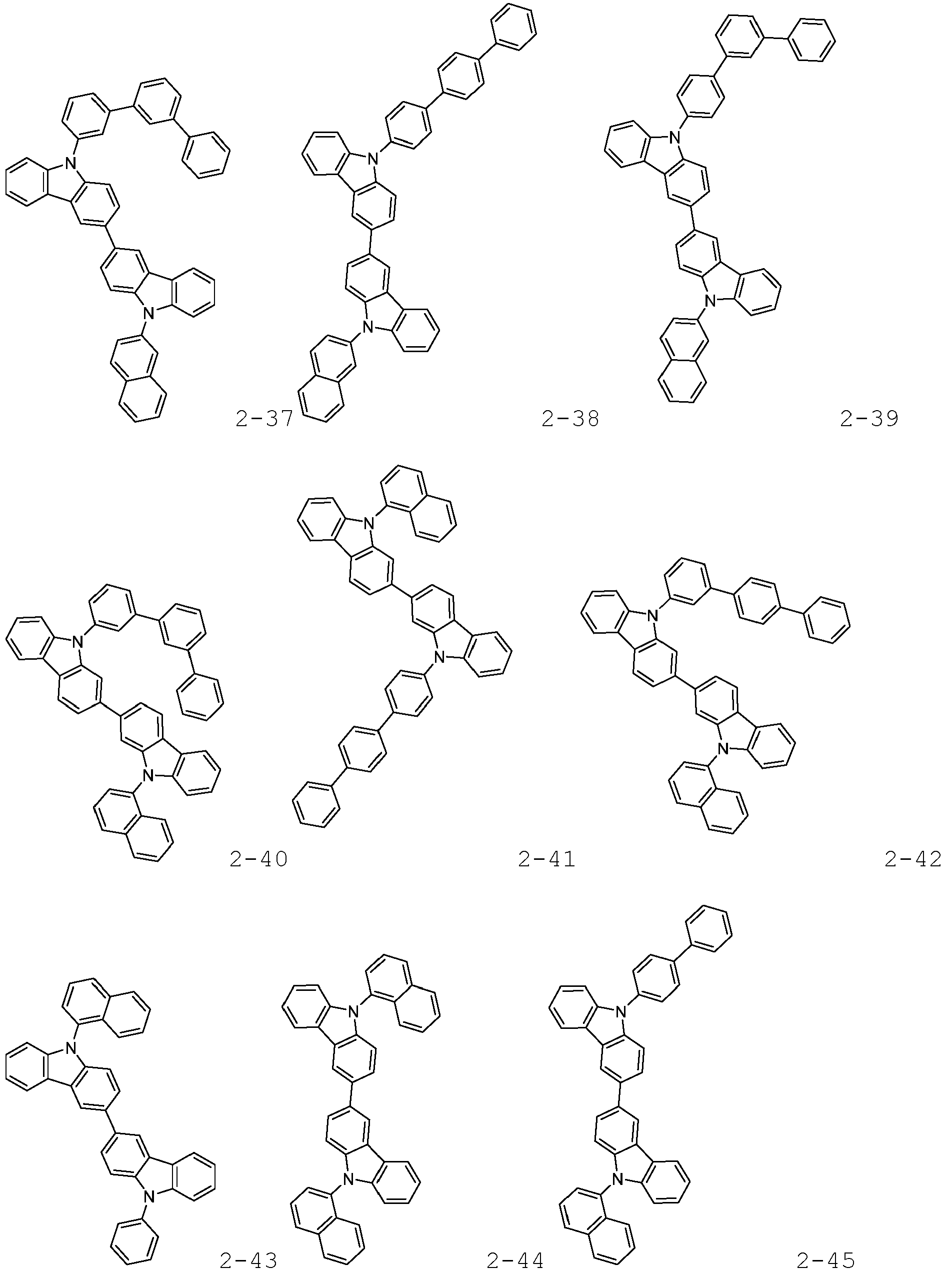

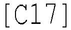

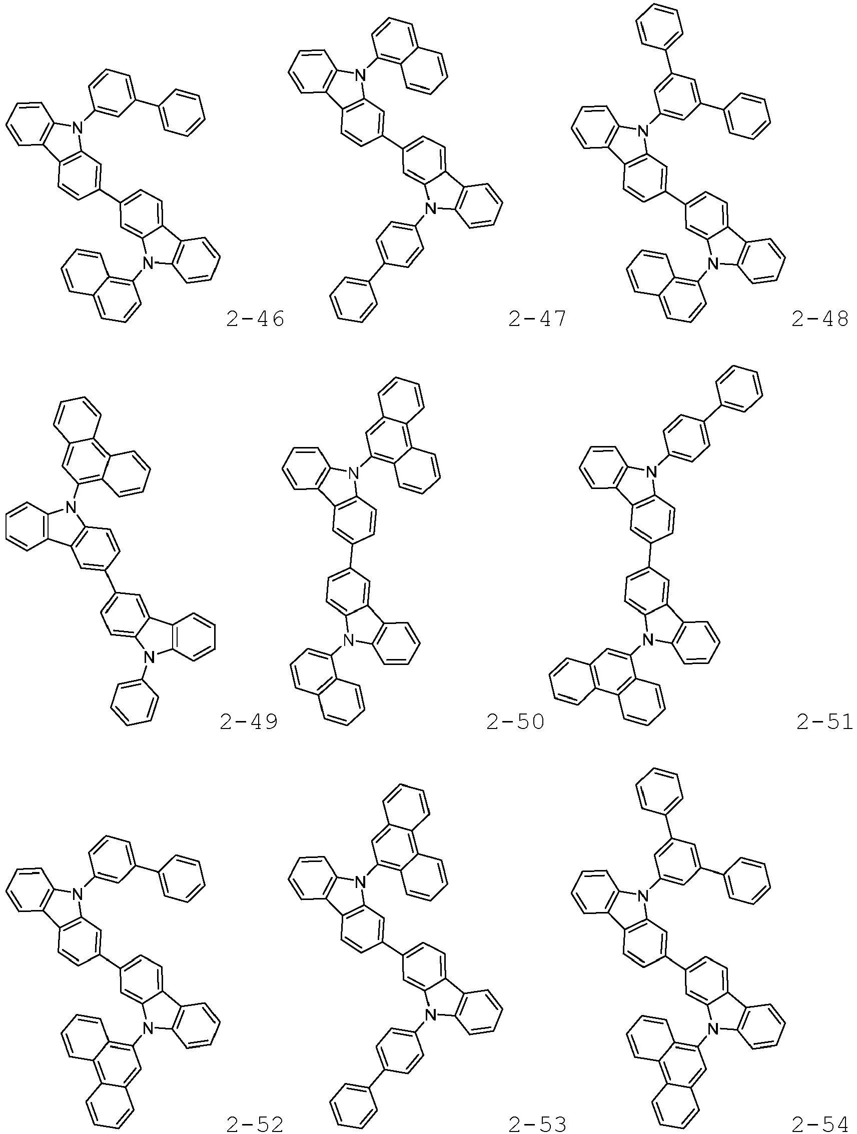

It is possible to provide an excellent organic EL device using the first host selected from among compounds represented by General Formula (1) and the second host selected from among compounds represented by General Formula (2) as host materials of a light-emitting layer.

The first host and the second host which are vapor-deposited from different vapor deposition sources can be used. However, preferably, they are mixed in advance before vapor deposition to prepare a pre-mixture, and the pre-mixture is vapor-deposited from one vapor deposition source at the same time to form a light-emitting layer. In this case, a light-emitting dopant material necessary for forming a light-emitting layer or another host used as necessary may be mixed into the pre-mixture. However, when there is a large difference in temperature at which a desired vapor pressure is obtained, vapor deposition may be performed from another vapor deposition source.

In addition, regarding the mixing ratio (weight ratio) between the first host and the second host, a proportion of the first host is 20 to 60%, preferably more than 20% and less than 55%, and more preferably 40 to 50% with respect to a total amount of the first host and the second host.

Next, the structure of the organic EL device of the present invention will be described with reference to the drawings, but the structure of the organic EL device of the present invention is not limited thereto.

Fig. 1 is a cross-sectional view showing a structure example of a general organic EL device used in the present invention, 1 represents a substrate, 2 represents an anode, 3 represents a hole injection layer, 4 represents a hole transport layer, 5 represents a light-emitting layer, 6 represents an electron transport layer, and 7 represents a cathode. The organic EL device of the present invention may have an exciton blocking layer adjacent to the light-emitting layer or may have an electron blocking layer between the light-emitting layer and the hole injection layer. The exciton blocking layer can be inserted into either on the side of the cathode or the side of the anode of the light-emitting layer and can be inserted into both sides at the same time. The organic EL device of the present invention has the anode, the light-emitting layer, and the cathode as essential layers, and may have a hole injection transport layer and an electron injection transport layer in addition to the essential layers, and may have additionally a hole blocking layer between the light-emitting layer and the electron injection transport layer. Here, the hole injection transport layer refers to either or both of the hole injection layer and the hole transport layer, and the electron injection transport layer refers to either or both of the electron injection layer and the electron transport layer.

A structure reverse to that of Fig. 1, that is, a structure in which a cathode 7, an electron transport layer 6, a light-emitting layer 5, a hole transport layer 4, and an anode 2 are laminated on a substrate 1 in that order, can be used, and in this case also, layers can be added or omitted as necessary.

### -Substrate-

The organic EL device of the present invention is preferably supported on a substrate. The substrate is not particularly limited, and those used in the organic EL device in the related art may be used, and those made of, for example, glass, a transparent plastic, or quartz, can be used.

### -Anode-

Regarding an anode material for an organic EL device, a material of a metal having a large work function (4 eV or more), an alloy, an electrically conductive compound or a mixture thereof is preferably used. Specific examples of such an electrode material include a metal such as Au, and a conductive transparent material such as CuI, indium tin oxide (ITO), SnO₂, and ZnO. In addition, an amorphous material such as IDIXO (In₂O₃-ZnO) which can form a transparent conductive film may be used. Regarding the anode, such an electrode material is used to form a thin film by a vapor-deposition or sputtering method, and a desired shape pattern may be formed by a photolithographic method, or if pattern accuracy is not particularly required (about 100 µm or more), a pattern may be formed via a desired shape mask when the electrode material is vapor-deposited or sputtered. Alternatively, when a coatable substance such as the organic conductive compound is used, a wet film formation method such as a printing method and a coating method can be used. When light is emitted from the anode, it is desirable that the transmittance be larger than 10% and the sheet resistance for the anode is preferably several hundreds of Ω/sq or less. The film thickness depends on the material, and it is generally 10 to 1,000 nm, and preferably selected in a range of 10 to 200 nm.

### -Cathode-

On the other hand, regarding a cathode material, a material of a metal having a small work function (4 eV or less) (an electron injection metal), an alloy, an electrically conductive compound, or a mixture thereof is used. Specific examples of such an electrode material include sodium, a sodium-potassium alloy, magnesium, lithium, a magnesium/copper mixture, a magnesium/silver mixture, a magnesium/aluminum mixture, a magnesium/indium mixture, an aluminum/aluminum oxide (Al₂O₃) mixture, indium, a lithium/aluminum mixture, and a rare earth metal. Among these, in consideration of electron injectability and durability with respect to oxidation and the like, a mixture of an electron injection metal and a second metal which is a stable metal having a larger work function value, for example, a magnesium/silver mixture, a magnesium/aluminum mixture, a magnesium/indium mixture, an aluminum/aluminum oxide mixture, a lithium/aluminum mixture, aluminum, and the like are suitable. The cathode can be produced by forming a thin film by a method such as vapor-depositing or sputtering of such a cathode material. In addition, a sheet resistance for the cathode is preferably several hundreds of Ω/sq or less, and the film thickness is generally 10 nm to 5 µm, and preferably selected in a range of 50 to 200 nm. Here, in order to transmit emitted light, if either the anode or the cathode of the organic EL device is transparent or translucent, light emission luminance is improved, which is advantageous.

In addition, after the metal with a film thickness of 1 to 20 nm is formed on the cathode, when a conductive transparent material exemplified in the description of the anode is formed thereon, a transparent or translucent cathode can be produced and by applying this, it is possible to produce a device in which both the anode and the cathode have transparency.

### -Light-emitting layer-

The light-emitting layer is a layer that emits light after excitons are generated when holes and electrons injected from the anode and the cathode, respectively, are recombined, and the light-emitting layer contains an organic light-emitting dopant material and a host material.

Regarding the host material in the light-emitting layer, the first host represented by General Formula (1) and the second host represented by General Formula (2) are used. In addition, one or more types of known host materials may be used in combination, and an amount used is 50 wt% or less, and preferably 25 wt% or less with respect to a total amount of host materials.

The first host and the second host are vapor-deposited from different vapor deposition sources. However, they are mixed in advance before vapor deposition to prepare a pre-mixture, and thus the first host and the second host can be vapor-deposited from one vapor deposition source at the same time.

When the first host and the second host are used by being mixed in advance, it is desirable that a difference in 50% weight reduction temperature (T₅₀) be small in order to produce an organic EL device having favorable characteristics with high reproducibility. The 50% weight reduction temperature is a temperature at which the weight is reduced by 50% when the temperature is raised to 550°C from room temperature at a rate of 10°C/min in TG-DTA measurement under a nitrogen stream reduced pressure (50 Pa). Vaporization due to vapor deposition or sublimation is considered most likely to occur around this temperature.

The difference of the 50% weight reduction temperature between the first host and the second host is preferably within 20°C and more preferably within 15°C. Regarding a premixing method, a known method such as pulverization and mixing can be used, and it is desirable to mix them as uniformly as possible.

When a phosphorescent dopant is used as the light-emitting dopant material, a phosphorescent dopant including an organometallic complex containing at least one metal selected from among ruthenium, rhodium, palladium, silver, rhenium, osmium, iridium, platinum, and gold may be used. Specifically, iridium complexes described in J. Am. Chem. Soc. 2001, 123, 4304 and Published Japanese Translation of PCT Application No. 2013-53051 are preferably used, but the present invention is not limited thereto.

Only one type of a phosphorescent dopant material may be contained in the light-emitting layer or two or more types thereof may be contained. A content of the phosphorescent dopant material is preferably 0.1 to 30 wt% and more preferably 1 to 20 wt% with respect to the host material.

The phosphorescent dopant material is not particularly limited, and specific examples thereof include the following.

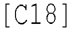

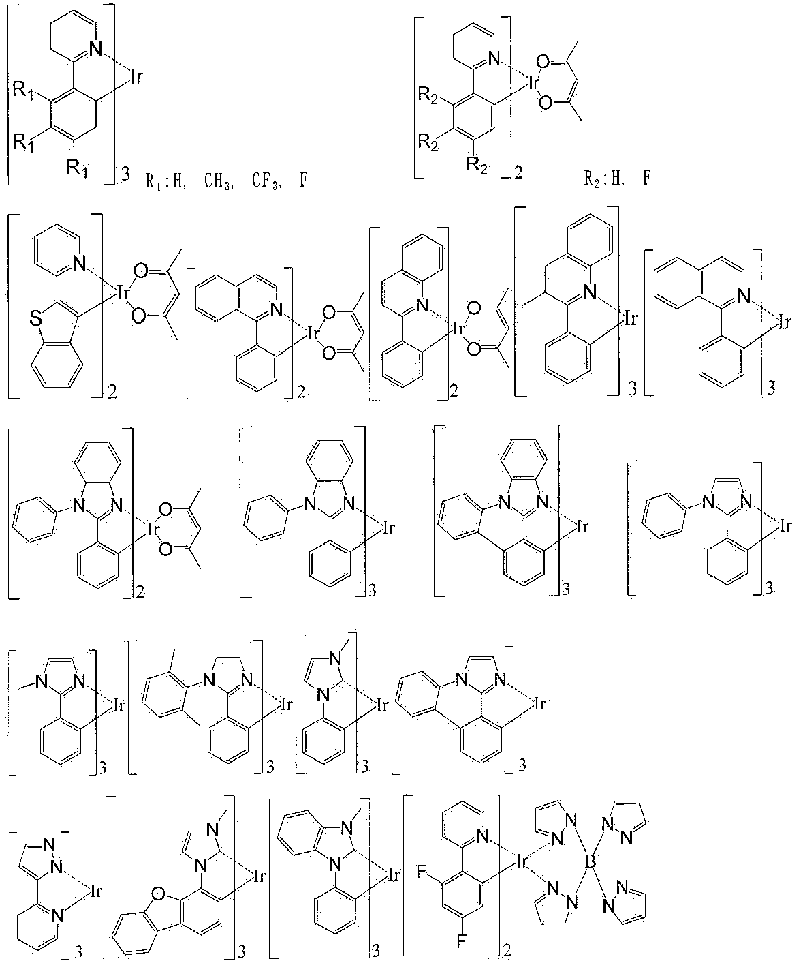

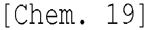

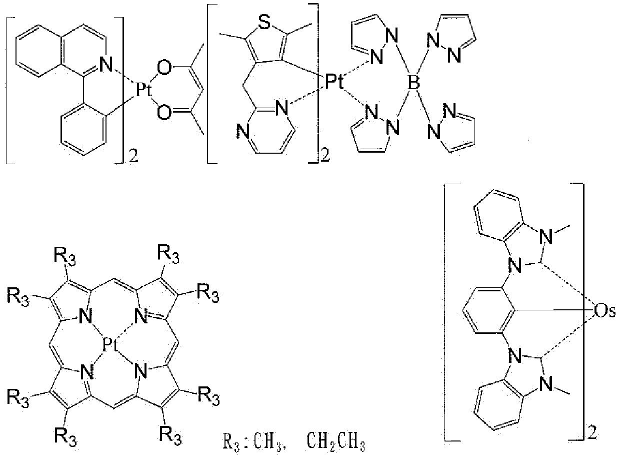

When a fluorescence-emitting dopant is used as a light-emitting dopant material, the fluorescence-emitting dopant is not particularly limited. Examples thereof include benzoxazole derivatives, benzothiazole derivatives, benzimidazole derivative, styrylbenzene derivatives, polyphenyl derivatives, diphenyl butadiene derivatives, tetraphenyl butadiene derivatives, naphthalimide derivative, coumarin derivatives, fused aromatic compound, perinone derivatives, oxadiazole derivative, oxazine derivatives, aldazine derivatives, pyrrolidine derivatives, cyclopentadiene derivatives, bisstyryl anthracene derivatives, quinacridone derivatives, pyrrolopyridine derivatives, thiadiazolopyridine derivatives, styrylamine derivatives, diketopyrrolopyrrole derivatives, aromatic dimethylidine compounds, metal complexes of 8-quinolinol derivatives, metal complexes of pyromethene derivatives, rare earth complexes, various metal complexes represented by transition metal complexes, polymer compounds such as polythiophene, polyphenylene, and polyphenylene vinylene, and organosilane derivatives. Preferable examples thereof include fused aromatic derivatives, styryl derivatives, diketopyrrolopyrrole derivatives, oxazine derivatives, pyromethene metal complexes, transition metal complexes, and lanthanoid complexes. More preferable examples thereof include naphthalene, pyrene, chrysene, triphenylene, benzo[c]phenanthrene, benzo[a]anthracene, pentacene, perylene, fluoranthene, acenaphthofluoranthene, dibenzo[a,j]anthracene, dibenzo[a,h]anthracene, benzo[a]naphthalene, hexacene, naphtho[2,1-f]isoquinoline, α-naphthaphenanthridine, phenanthrooxazole, quinolino[6,5-f]quinoline, and benzothiophanthrene. These may have an alkyl group, an aryl group, an aromatic heterocyclic group, or a diarylamino group as a substituent.

Only one type of a fluorescence-emitting dopant material may be contained in the light-emitting layer or two or more types thereof may be contained. A content of the fluorescence-emitting dopant material is preferably 0.1 to 20% and more preferably 1 to 10% with respect to the host material.

When a thermally activated delayed fluorescence-emitting dopant is used as a light-emitting dopant material, the thermally activated delayed fluorescence-emitting dopant is not particularly limited. Examples thereof include metal complexes such as a tin complex and a copper complex, indolocarbazole derivatives described in WO2011/070963, cyanbenzene derivatives described in Nature 2012, 492, 234, carbazole derivatives, phenazine derivatives described in Nature Photonics 2014, 8, 326, oxadiazole derivatives, triazole derivatives, sulfone derivatives, phenoxazine derivatives, acridine derivatives.

The thermally activated delayed fluorescence-emitting dopant material is not particularly limited, and specific examples thereof include the following.

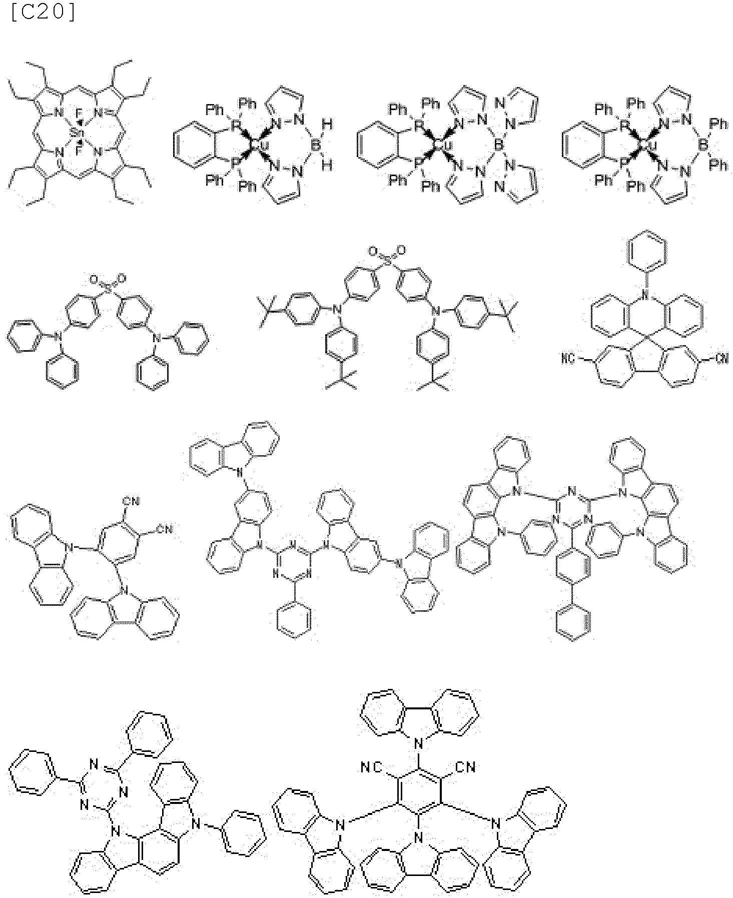

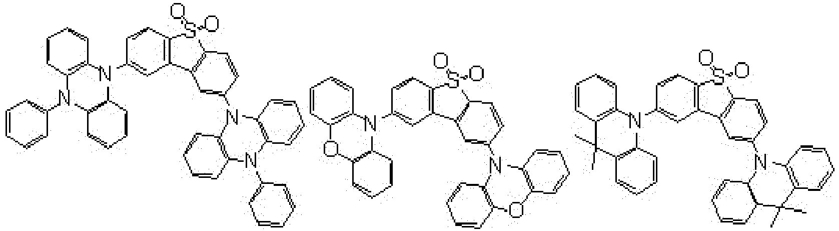

Only one type of a thermally activated delayed fluorescence-emitting dopant material may be contained in the light-emitting layer or two or more types thereof may be contained. In addition, a mixture of thermally activated delayed fluorescence-emitting dopant and a phosphorescent dopant or a fluorescence-emitting dopant may be used. A content of the thermally activated delayed fluorescence-emitting dopant material is preferably 0.1 to 50% and more preferably 1 to 30% with respect to the host material.

### -Injection layer-

The injection layer is a layer that is provided between an electrode and an organic layer in order to lower a driving voltage and improve light emission luminance, and includes a hole injection layer and an electron injection layer, and may be present between the anode and the light-emitting layer or the hole transport layer, and between the cathode and the light-emitting layer or the electron transport layer. The injection layer can be provided as necessary.

### -Hole blocking layer-

The hole blocking layer has a function of the electron transport layer in a broad sense, and is made of a hole blocking material having a function of transporting electrons and a significantly low ability to transport holes. When the layer blocks holes while transporting electrons, a probability of recombining electrons and holes in the light-emitting layer can be improved.

A known hole blocking layer material can be used for the hole blocking layer, and a compound represented by General Formula (1) is preferably contained.

### -Electron blocking layer-

The electron blocking layer has a function of a hole transport layer in a broad sense and blocks electrons while transporting holes, and thus can improve a probability of recombining electrons and holes in the light-emitting layer.

Regarding the material of the electron blocking layer, a known electron blocking layer material can be used and a material of the hole transport layer to be described below can be used as necessary. The film thickness of the electron blocking layer is preferably 3 to 100 nm, and more preferably 5 to 30 nm.

### -Exciton blocking layer-

The exciton blocking layer is a layer for blocking diffusion of excitons generated when holes and electrons are recombined in the light-emitting layer in a charge transport layer, and when this layer is inserted, excitons can be efficiently confined in the light-emitting layer, and the luminous efficiency of the device can be improved. The exciton blocking layer can be inserted between two adjacent light-emitting layers in a device in which two or more light-emitting layers are adjacent to each other.

Regarding the material of the exciton blocking layer, a known exciton blocking layer material can be used. Examples thereof include 1,3-dicarbazolyl benzene (mCP) and bis(2-methyl-8-quinolinolato)-4-phenylphenolato aluminum (III)(BAlq).

### -Hole transport layer-

The hole transport layer is made of a hole transport material having a function of transporting holes, and a single hole transport layer or a plurality of hole transport layers can be provided.

The hole transport material has either hole injection or transport properties or electron barrier properties, and may be an organic material or an inorganic material. For the hole transport layer, any one selected from among conventionally known compounds can be used. Examples of such a hole transport material include porphyrin derivatives, arylamine derivatives, triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, styryl anthracene derivatives, fluorenone derivatives, hydrazone derivatives, stilbene derivatives, silazane derivatives, an aniline copolymer, and a conductive polymer oligomer, and particularly a thiophene oligomer. Porphyrin derivatives, arylamine derivatives, or styrylamine derivatives are preferably used. An arylamine compound is more preferably used.

### -Electron transport layer-

The electron transport layer is made of a material having a function of transporting electrons, and a single electron transport layer or a plurality of electron transport layers can be provided.

The electron transport material (which may also be a hole blocking material) may have a function of transferring electrons injected from the cathode to the light-emitting layer. For the electron transport layer, any one selected from among conventionally known compounds can be used, and examples thereof include polycyclic aromatic derivatives such as naphthalene, anthracene, and phenanthroline, tris(8-quinolinolato)aluminum (III) derivatives, phosphine oxide derivatives, nitro-substituted fluorene derivatives, diphenylquinone derivatives, thiopyrandioxide derivatives, carbodiimide, freorenylidene methane derivatives, anthraquinodimethane and anthrone derivatives, bipyridine derivatives, quinoline derivatives, oxadiazole derivatives, benzimidazole derivatives, benzothiazole derivatives, and indolocarbazole derivatives. In addition, a polymer material in which such a material is introduced into a polymer chain or such a material is used for a main chain of a polymer can be used.

### [Examples]

While the present invention will be described below in more detail with reference to examples, the present invention is not limited to these examples, and can be implemented in various forms without departing from the scope and spirit thereof.

### Example 1

On a glass substrate on which an anode made of ITO with a film thickness of 110 nm was formed, respective thin films were laminated using a vacuum vapor deposition method at a degree of vacuum of 4.0 × 10⁻⁵ Pa. First, HAT-CN was formed with a thickness of 25 nm as a hole injection layer on ITO, and next NPD was formed with a thickness of 30 nm as a hole transport layer. Next, HT-1 was formed with a thickness of 10 nm as an electron blocking layer. Next, Compound 1-1 as a first host, Compound 2-1 as a second host, and Ir(ppy)₃ as a light-emitting dopant were co-vapor-deposited from different vapor deposition sources to form a light-emitting layer with a thickness of 40 nm. In this case, co-vapor deposition was performed under vapor deposition conditions such that the concentration of Ir(ppy)₃ was 10 wt%, and the weight ratio between the first host and the second host was 30:70. Next, ET-1 was formed with a thickness of 20 nm as an electron transport layer. In addition, LiF was formed with a thickness of 1 nm as an electron injection layer on the electron transport layer. Finally, Al was formed with a thickness of 70 nm as a cathode on the electron injection layer to produce an organic EL device.

### Examples 2 to 14

Organic EL devices were produced in the same manner as in Example 1 except that, unlike Example 1, compounds shown in Table 1 were used as the first host and the second host.

### Examples 15 to 17

The first host and the second host were mixed in advance to prepare a pre-mixture, which was co-vapor-deposited from the same vapor deposition source.

Organic EL devices were produced in the same manner as in Example 1 except that, unlike in Example 1, pre-mixtures prepared by weighing out the first host (0.30 g) and the second host (0.70 g) and mixing them while grinding them in a mortar were used.

### Examples 18 to 23

The first host and the second host were mixed in advance to prepare a pre-mixture, which was co-vapor-deposited from the same vapor deposition source, and a hole blocking layer was additionally provided to produce an organic EL device.

Organic EL devices were produced in the same manner as in Examples 15 to 17 except that, unlike in Examples 15 to 17, a light-emitting layer was formed, Compound 1-4 was then formed with a thickness of 10 nm as a hole blocking layer, and ET-1 was formed with a thickness of 10 nm as an electron transport layer.

The evaluation results of the produced organic EL devices are shown in Table 1. In the table, the luminance, driving voltage, and luminous efficiency were values at a drive current of 20 mA/cm², and were initial characteristics. LT70 was a time taken for the initial luminance to be reduced to 70%, and was a lifespan characteristic.

**[Table 1]**

| Ex. | First host compd. | Second host compd. | Luminance (cd/m2) | Voltage (V) | Power efficiency (lm/W) | LT70 (h) |
|---|---|---|---|---|---|---|
| 1 | 1-1 | 2-1 | 10200 | 3.9 | 41.1 | 1000 |
| 2 | 1-1 | 2-3 | 10300 | 3.9 | 41.5 | 1000 |
| 3 | 1-2 | 2-1 | 10300 | 3.9 | 41.5 | 1100 |
| 4 | 1-2 | 2-3 | 10200 | 4.0 | 40.1 | 1100 |
| 5 | 1-3 | 2-1 | 10200 | 4.0 | 40.1 | 1100 |
| 6 | 1-3 | 2-3 | 10100 | 4.0 | 39.7 | 1100 |
| 7 | 1-4 | 2-1 | 10000 | 3.9 | 40.3 | 1200 |
| 8 | 1-4 | 2-3 | 10000 | 3.8 | 41.3 | 1200 |
| 9 | 1-19 | 2-1 | 10000 | 3.9 | 40.3 | 1000 |
| 10 | 1-19 | 2-3 | 10000 | 4.0 | 39.3 | 1000 |
| 11 | 1-20 | 2-1 | 10000 | 3.9 | 40.3 | 1000 |
| 12 | 1-20 | 2-3 | 10000 | 3.9 | 40.3 | 1000 |
| 13 | 1-42 | 2-1 | 10000 | 3.9 | 40.3 | 1000 |
| 14 | 1-42 | 2-3 | 10000 | 3.9 | 40.3 | 1000 |
| 15 | 1-4 | 2-3 | 10000 | 3.8 | 41.3 | 1250 |
| 16 | 1-19 | 2-3 | 10000 | 4.0 | 39.3 | 1000 |
| 17 | 1-20 | 2-3 | 10000 | 3.9 | 40.3 | 1100 |
| 18 | 1-4 | 2-1 | 10500 | 4.0 | 41.2 | 1100 |
| 19 | 1-4 | 2-3 | 10400 | 3.9 | 41.9 | 1100 |
| 20 | 1-19 | 2-1 | 10700 | 4.0 | 42.0 | 1050 |
| 21 | 1-19 | 2-3 | 10800 | 4.0 | 42.4 | 1000 |
| 22 | 1-20 | 2-1 | 10500 | 3.9 | 42.3 | 1050 |
| 23 | 1-20 | 2-3 | 10700 | 4.0 | 42.0 | 1050 |

### Comparative Example 1

An organic EL device was produced in the same manner as in Example 1 except that, unlike in Example 1, Compound 1-1 alone was used as the host. The thickness of the light-emitting layer and the light-emitting dopant concentration were the same as those in Example 1.

### Comparative Examples 2 to 8

Organic EL devices were produced in the same manner as in Comparative Example 1 except that the compounds alone shown in Table 2 were used as the host.

### Comparative Examples 9 and 10

Organic EL devices were produced in the same manner as in Example 1 except that, unlike in Example 1, the compound A was used as the first host, and Compound 2-1 or Compound 2-3 was used as the second host.

### Comparative Examples 11 and 12

Organic EL devices were produced in the same manner as in Comparative Examples 9 and 10 except that, unlike in Comparative Examples 9 and 10, the compound B was used as the first host.

### Comparative Examples 13 and 14

Organic EL devices were produced in the same manner as in Comparative Examples 9 and 10 except that, unlike Comparative Examples 9 and 10, the compound C was used as the first host.

### Comparative Examples 15 and 16

Organic EL devices were produced in the same manner as in Comparative Examples 9 and 10 except that, unlike Comparative Examples 9 and 10, the compound D was used as the first host.

The evaluation results of the produced organic EL devices are shown in Table 2.

**[Table 2]**

| Comp. Ex. | First host compd. | Second host compd. | Luminance (cd/m2) | Voltage (V) | Power efficiency (lm/W) | LT70 (h) |
|---|---|---|---|---|---|---|
| 1 | 1-1 | - | 7000 | 3.4 | 32.3 | 400 |
| 2 | 1-2 | - | 7100 | 3.4 | 32.8 | 400 |
| 3 | 1-4 | - | 7000 | 3.3 | 33.3 | 450 |
| 4 | 1-19 | - | 7000 | 3.3 | 33.3 | 500 |
| 5 | 1-20 | - | 7000 | 3.4 | 32.3 | 500 |
| 6 | 1-42 | - | 7000 | 3.2 | 34.4 | 500 |
| 7 | - | 2-1 | 9500 | 4.6 | 32.4 | 400 |
| 8 | - | 2-3 | 9000 | 4.5 | 31.4 | 450 |
| 9 | A | 2-1 | 9500 | 4.5 | 33.2 | 700 |
| 10 | A | 2-3 | 9500 | 4.4 | 33.9 | 700 |
| 11 | B | 2-1 | 9000 | 4.6 | 30.7 | 650 |
| 12 | B | 2-3 | 9000 | 4.5 | 31.4 | 650 |
| 13 | C | 2-1 | 10500 | 4.7 | 35.1 | 700 |
| 14 | C | 2-3 | 10500 | 4.6 | 35.9 | 750 |
| 15 | D | 2-1 | 10000 | 4.6 | 34.1 | 750 |
| 16 | D | 2-3 | 10000 | 4.6 | 34.1 | 750 |

Based on Table 1, it was found that Examples 1 to 23 had improved power efficiency and lifespan characteristics, and exhibited favorable characteristics.

### Example 24

On a glass substrate on which an anode made of ITO with a film thickness of 110 nm was formed, respective thin films were laminated using a vacuum vapor deposition method at a degree of vacuum of 4.0 × 10⁻⁵ Pa. First, HAT-CN was formed with a thickness of 25 nm as a hole injection layer on ITO. Next, NPD was formed with a thickness of 45 nm as a hole transport layer. Next, HT-1 was formed with a thickness of 10 nm as an electron blocking layer. Next, Compound 1-1 as a first host, Compound 2-1 as a second host and Ir(piq)₂acac as a light-emitting dopant were co-vapor-deposited from different vapor deposition sources to form a light-emitting layer with a thickness of 40 nm. In this case, co-vapor-deposition was performed under vapor deposition conditions such that the concentration of Ir(piq)₂acac was 6.0 wt%. Next, ET-1 was formed with a thickness of 37.5 nm as an electron transport layer. Then, LiF was formed with a thickness of 1 nm as an electron injection layer on the electron transport layer. Finally, Al was formed with a thickness of 70 nm as a cathode on the electron injection layer to produce an organic EL device.

### Examples 25 to 37

Organic EL devices were produced in the same manner as in Example 24 except that, unlike Example 24, compounds shown in Table 3 were used as the first host and the second host.

The evaluation results of the produced organic EL devices are shown in Table 3. Here, LT95 was a time taken for the initial luminance to be reduced to 95%, and was a lifespan characteristic.

**[Table 3]**

| Ex. | First host compd. | Second host compd. | Luminance (cd/m2) | Voltage (V) | Power efficiency (lm/W) | LT95 (h) |
|---|---|---|---|---|---|---|
| 24 | 1-1 | 2-1 | 4500 | 3.9 | 18.1 | 200 |
| 25 | 1-1 | 2-3 | 4600 | 3.8 | 19.0 | 200 |
| 26 | 1-2 | 2-1 | 4600 | 3.8 | 19.0 | 250 |
| 27 | 1-2 | 2-3 | 4500 | 3.7 | 19.1 | 250 |
| 28 | 1-3 | 2-1 | 4500 | 3.7 | 19.1 | 250 |
| 29 | 1-3 | 2-3 | 4500 | 3.6 | 19.6 | 280 |
| 30 | 1-4 | 2-1 | 4500 | 3.9 | 18.1 | 280 |
| 31 | 1-4 | 2-3 | 4600 | 3.8 | 19.0 | 280 |
| 32 | 1-19 | 2-1 | 4500 | 3.7 | 19.1 | 200 |
| 33 | 1-19 | 2-3 | 4000 | 3.4 | 18.5 | 200 |
| 34 | 1-20 | 2-1 | 4000 | 3.4 | 18.5 | 200 |
| 35 | 1-20 | 2-3 | 4000 | 3.4 | 18.5 | 250 |
| 36 | 1-42 | 2-1 | 4000 | 3.4 | 18.5 | 250 |
| 37 | 1-42 | 2-3 | 4000 | 3.4 | 18.5 | 250 |

### Comparative Example 17

An organic EL device was produced in the same manner as in Example 24 except that, unlike Example 24, Compound 1-1 alone was used as the host. The thickness of the light-emitting layer and the light-emitting dopant concentration were the same as those in Example 24.

### Comparative Examples 18 to 24

Organic EL devices were produced in the same manner as in Comparative Example 17 except that the compounds alone shown in Table 4 were used as the host.

### Comparative Examples 25 and 26

Organic EL devices were produced in the same manner as in Example 24 except that, unlike Example 24, the compound A was used as the first host and Compound 2-1 or Compound 2-3 was used as the second host.

### Comparative Examples 27 and 28

Organic EL devices were produced in the same manner as in Comparative Examples 25 and 26 except that, unlike Comparative Examples 25 and 26, the compound B was used as the first host.

### Comparative Examples 29 and 30

Organic EL devices were produced in the same manner as in Comparative Examples 25 to 26 except that, unlike Comparative Examples 25 and 26, the compound C was used as the first host.

### Comparative Examples 31 and 32

Organic EL devices were produced in the same manner as in Comparative Examples 25 and 26 except that, unlike Comparative Examples 25 and 26, the compound D was used as the first host.

The evaluation results of the produced organic EL devices are shown in Table 4.

**[Table 4]**

| Comp. Ex. | First host compd. | Second host compd. | Luminance (cd/m2) | Voltage (V) | Power efficiency (lm/W) | LT95 (h) |
|---|---|---|---|---|---|---|
| 17 | 1-1 | - | 3000 | 3.4 | 13.9 | 80 |
| 18 | 1-2 | - | 3000 | 3.4 | 13.9 | 100 |
| 19 | 1-4 | - | 3000 | 3.3 | 14.3 | 100 |
| 20 | 1-19 | - | 3500 | 3.3 | 16.7 | 80 |
| 21 | 1-20 | - | 3000 | 3.4 | 13.9 | 90 |
| 22 | 1-42 | - | 3200 | 3.6 | 14.0 | 90 |
| 23 | - | 2-1 | 3000 | 4.6 | 10.2 | 80 |
| 24 | - | 2-3 | 3500 | 4.5 | 12.2 | 90 |
| 25 | A | 2-1 | 4000 | 4.4 | 14.3 | 110 |
| 26 | A | 2-3 | 4000 | 4.4 | 14.6 | 110 |
| 27 | B | 2-1 | 4000 | 4.5 | 14.0 | 100 |
| 28 | B | 2-3 | 4000 | 4.5 | 12.2 | 100 |
| 29 | C | 2-1 | 4000 | 4.7 | 13.4 | 150 |
| 30 | C | 2-3 | 4000 | 4.6 | 13.7 | 150 |
| 31 | D | 2-1 | 4000 | 4.6 | 13.7 | 120 |
| 32 | D | 2-3 | 4000 | 4.6 | 13.7 | 120 |

Based on Table 3, it was found that Examples 24 to 37 had improved power efficiency and lifespan characteristics and exhibited favorable characteristics.

Compounds used in examples are shown below.

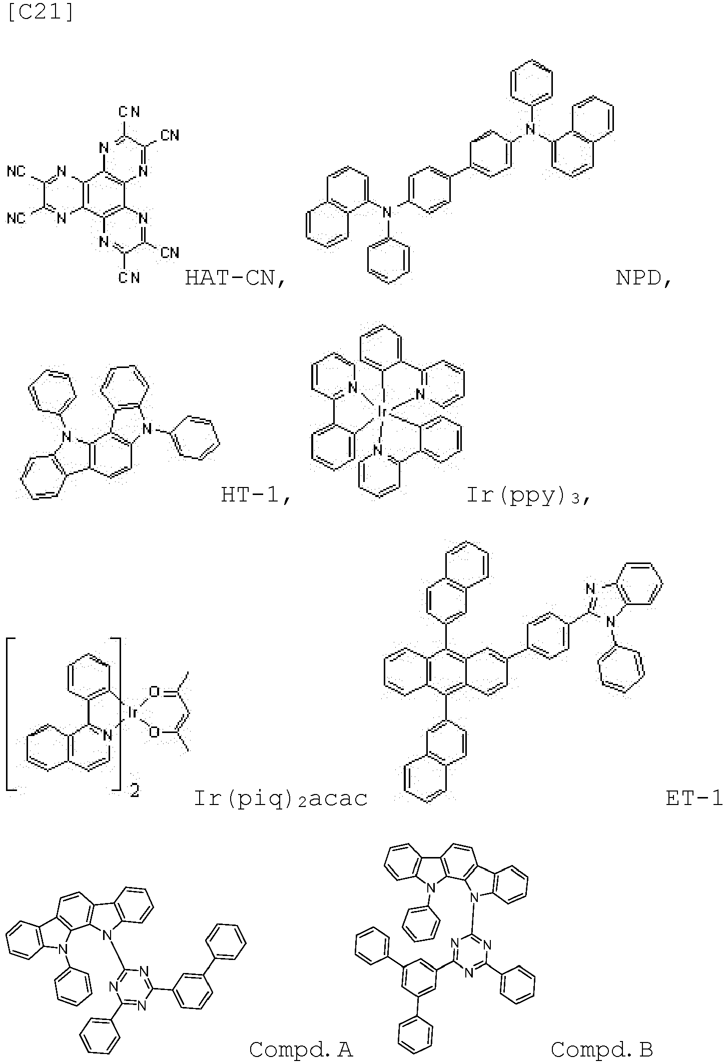

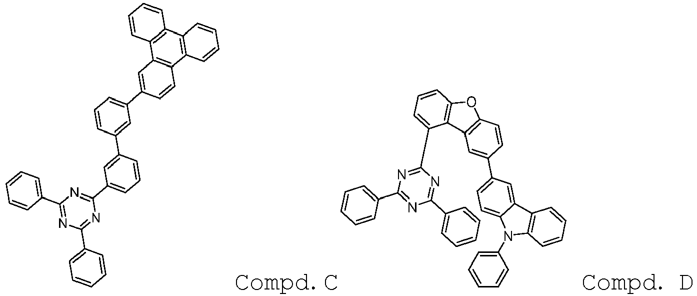

### [Industrial Applicability]

The organic electroluminescent device of the present invention has less outflow of energy from the inside of the light-emitting layer and can achieve high efficiency and a prolonged lifespan at a low voltage.

## Claims

1. An organic electroluminescent device having at least one light-emitting layer between an anode and a cathode which face each other, and in which at least one light-emitting layer is comprised a vapor deposition layer containing a first host selected from among compounds represented by the following General Formula (1), a second host selected from among compounds represented by the following General Formula (2), and a light-emitting dopant material: 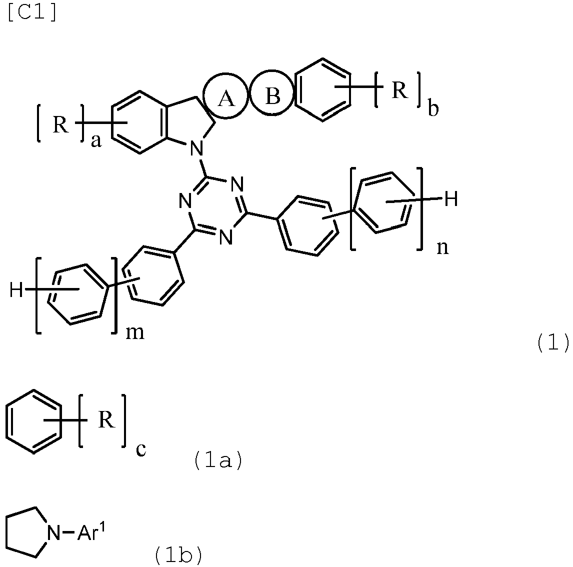
wherein, the ring A is an aromatic hydrocarbon ring represented by Formula (1a), the ring B is a heterocycle represented by Formula (1b), and the ring A and the ring B are each fused to an adjacent ring at any position,
Ar¹ represents a phenyl group, a biphenyl group or a terphenyl group,
R's independently represent an aliphatic hydrocarbon group having 1 to 10 carbon atoms, an aromatic hydrocarbon group having 6 to 10 carbon atoms, or an aromatic heterocyclic group having 3 to 12 carbon atoms,
a, b, and c each independently represent an integer of 0 to 3, and
m and n represent the number of repetitions, and each independently represent an integer of 0 to 4, here, m = n never being satisfied, and m + n ≥ 2, 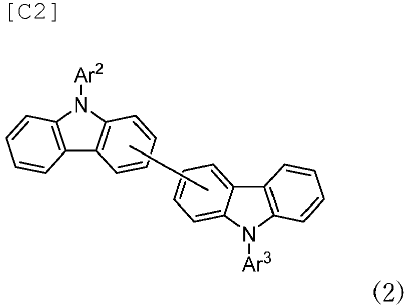
wherein, Ar² and Ar³ independently represent an aromatic hydrocarbon group having 6 to 14 carbon atoms or a linked aromatic group in which two or three of the aromatic hydrocarbon groups are linked, and at least one of Ar² and Ar³ represents a fused aromatic hydrocarbon group.

2. The organic electroluminescent device according to claim 1,
wherein the compound represented by General Formula (2) is a compound represented by the following General Formula (3) : 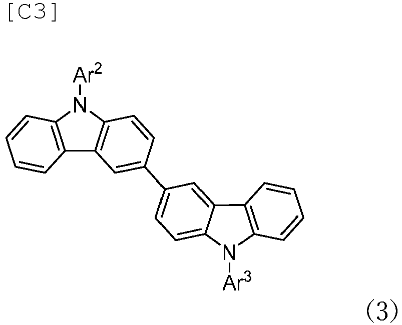 wherein, Ar² and Ar³ are the same as Ar² and Ar³ in General Formula (2).

3. The organic electroluminescent device according to claim 1,
wherein Ar² is a naphthyl group or a phenanthryl group.

4. The organic electroluminescent device according to claim 1,
wherein the compound represented by General Formula (1) is a compound represented by any of the following General Formula (4) to (9): 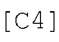 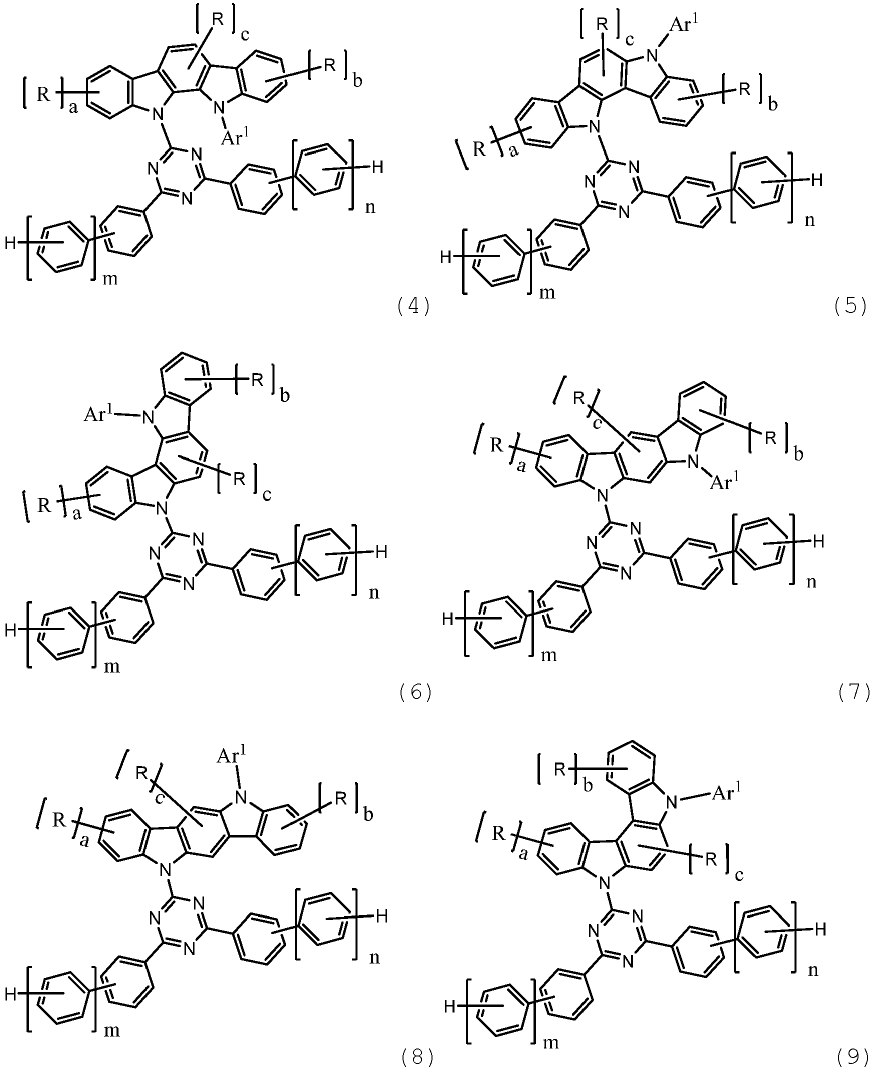 wherein, Ar^{l}, R, a to c, m, and n are the same as those in General Formula (1).

5. The organic electroluminescent device according to claim 1,
wherein a proportion of the first host is larger than 20 wt% and less than 55 wt% with respect to a total amount of the first host and the second host.

6. The organic electroluminescent device according to claim 1,
wherein the light-emitting dopant material is an organometallic complex containing at least one metal selected from the group consisting of ruthenium, rhodium, palladium, silver, rhenium, osmium, iridium, platinum and gold.

7. The organic electroluminescent device according to claim 1,
wherein the light-emitting dopant material is a thermally activated delayed fluorescence-emitting dopant material.

8. The organic electroluminescent device according to claim 1,
wherein a hole blocking layer is provided adjacent to the light-emitting layer, and the hole blocking layer contains the compound represented by General Formula (1).

9. A method of producing an organic electroluminescent device, comprising
a process in which, when the organic electroluminescent device according to any one of claims 1 to 9 is produced, a first host and a second host are mixed to prepare a pre-mixture, a host material containing the pre-mixture is then vapor-deposited to form a light-emitting layer.

10. The method of producing an organic electroluminescent device according to claim 10,
wherein a difference of the 50% weight reduction temperature between the first host and the second host is within 20°C.
